# EUROPEAN PATENT APPLICATION

(11) **EP 4 372 798 A2**
(43) Date of publication of application: **22.05.2024**
(21) Application number: 23210454.7
(22) Date of filing: 16.11.2023
(51) Int. Cl.: H01L 21/8234, H01L 27/02, G06F 30/32, H01L 27/088, H01L 21/8238, H01L 27/092

(54) **INTEGRATED CIRCUIT INCLUDING STANDARD CELLS AND METHOD OF DESIGNING THE SAME**

(30) Priority: 18.11.2022 KR 20220155661; 14.03.2023 KR 20230033463
(71) Applicant: Samsung Electronics Co., Ltd., Suwon-si, Gyeonggi-do 16677 (KR)
(72) Inventor: YOU, Hyeongyu, 16677 Suwon-si (KR); KIM, Wootae, 16677 Suwon-si (KR); KIM, Juyeon, 16677 Suwon-si (KR); DO, Jungho, 16677 Suwon-si (KR); YU, Jisu, 16677 Suwon-si (KR); LEE, Seungyoung, 16677 Suwon-si (KR)
(74) Representative: Marks & Clerk LLP

(57) **Abstract**

Provided is an integrated circuit (30) including a first cell (C31) provided in a first row (R1) extending in a first horizontal direction (X), a second cell (C32) provided in a second row (R2) extending in the first horizontal direction, the first row and the second row being adjacent to each other, a first power line (PL32) extending in the first horizontal direction along a first boundary between the first row and the second row in a power line layer, the first power line configured to receive a first supply voltage (VSS), a first contact (CA31) extending from the first cell to the second cell in a second horizontal direction (Y) crossing the first horizontal direction, and a first downward via extending in a vertical direction from a bottom surface of the first contact to a top surface of the first power line.

## Description

### BACKGROUND

### 1. Field

The disclosure relates to an integrated circuit, and more particularly, to an integrated circuit including a standard cell and a method of designing the same.

### 2. Description of Related Art

An integrated circuit for processing a digital signal may include standard cells, and each of the standard cells may have a unique function and structure. Due to the development of semiconductor processes, the size of standard cells may be reduced, and accordingly, routing for supplying power to standard cells may be difficult.

### SUMMARY

The disclosure provides an integrated circuit and a method of designing the same that provide a reduced area and improved power delivery network.

According to an aspect of the disclosure, there is provided an integrated circuit including: a first cell provided in a first row extending in a first horizontal direction; a second cell provided in a second row extending in the first horizontal direction, the first row and the second row being adjacent to each other; a first power line extending in the first horizontal direction along a first boundary between the first row and the second row in a power line layer, the first power line configured to receive a first supply voltage; a first contact extending from the first cell to the second cell in a second horizontal direction intersecting the first horizontal direction; and a first via extending in a vertical direction from a bottom surface of the first contact to a top surface of the first power line.

According to another aspect of the disclosure, there is provided an integrated circuit including: a first power line extending in a first horizontal direction in a power line layer, the first power line configured to receive a first supply voltage; a plurality of first contacts, each of the plurality of first contacts extending in a second horizontal direction intersecting the first horizontal direction and connected to a first source/drain region and a second source/drain region adjacent to each other in the second horizontal direction; and a plurality of first vias respectively extending from bottom surfaces of the plurality of first contacts to a top surface of the first power line in a vertical direction, wherein the plurality of first contacts are arranged at equal intervals in the first horizontal direction.

According to another aspect of the disclosure, there is provided a method of manufacturing an integrated circuit, the method including: obtaining first input data including first information about the integrated circuit including a plurality of standard cells; arranging, in a power line layer, a plurality of power lines extending in a first horizontal direction; providing a plurality of virtual contacts, each extending in a second horizontal direction intersecting with the first horizontal direction and overlapping one of the plurality of power lines; arranging the plurality of standard cells based on the plurality of virtual contacts; and generating output data including second information of a layout including the plurality of standard cells, wherein the arranging of the plurality of standard cells includes arranging a first source region of a first transistor of a first standard cell, among the plurality of standard cells, to overlap a first virtual contact, among the plurality of virtual contacts.

At least some of the above and other features of the invention are set out in the claims.

### BRIEF DESCRIPTION OF DRAWINGS

Embodiments will be more clearly understood from the following detailed description taken in conjunction with the accompanying drawings in which:
FIGS. 1A and 1B are diagrams illustrating layouts of an integrated circuit according to example embodiments;
FIGS. 2A, 2B, 2C and 2D are diagrams illustrating examples of devices according to example embodiments;
FIG. 3 is a plan view illustrating a layout of an integrated circuit according to an example embodiment;
FIGS. 4A and 4B are cross-sectional views illustrating examples of a cross-section of an integrated circuit according to example embodiments;
FIGS. 5A and 5B are diagrams illustrating layouts of an integrated circuit according to example embodiments;
FIGS. 6A and 6B are diagrams illustrating layouts of an integrated circuit according to example embodiments;
FIGS. 7A and 7B are cross-sectional views illustrating examples of a cross-section of an integrated circuit according to example embodiments;
FIG. 8 is a flowchart illustrating a method for fabricating an integrated circuit, according to an example embodiment;
FIG. 9 is a flowchart illustrating a method for fabricating an integrated circuit, according to an example embodiment;
FIG. 10 is a flowchart illustrating a method of fabricating an integrated circuit, according to an example embodiment;
FIG. 11 is a flowchart illustrating a method of fabricating an integrated circuit, according to an example embodiment;
FIG. 12 is a diagram illustrating a layout of an integrated circuit according to an example embodiment;
FIG. 13 is a diagram illustrating a layout of an integrated circuit according to an example embodiment;
FIG. 14 is a diagram illustrating a layout of an integrated circuit according to an example embodiment;
FIG. 15 is a flowchart illustrating a method of fabricating an integrated circuit, according to an example embodiment, and a diagram illustrating examples of a layout;
FIG. 16 is a flowchart illustrating a method of fabricating an integrated circuit, according to an example embodiment;
FIGS. 17A and 17B are flowcharts illustrating methods of fabricating an integrated circuit, according to an example embodiments;
FIG. 18 is a block diagram illustrating a system-on-chip according to an example embodiment; and
FIG. 19 is a block diagram illustrating a computing system including a memory storing a program, according to an example embodiment.

### DETAILED DESCRIPTION

Below, embodiments of the disclosure will be described in detail and clearly to such an extent that an ordinary one in the art easily implements the invention. The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Throughout the specification, when a component is described as being "connected to," or "coupled to" another component, it may be directly "connected to," or "coupled to" the other component, or there may be one or more other components intervening therebetween. In contrast, when an element is described as being "directly connected to," or "directly coupled to" another element, there can be no other elements intervening therebetween. Likewise, similar expressions, for example, "between" and "immediately between," and "adjacent to" and "immediately adjacent to," are also to be construed in the same way. As used herein, the term "and/or" includes any one and any combination of any two or more of the associated listed items.

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

The terminology used herein is for describing various examples only and is not to be used to limit the disclosure. The articles "a," "an," and "the" are intended to include the plural forms as well, unless the context clearly indicates otherwise. The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment (e.g., as to what an example or embodiment may include or implement) means that at least one example or embodiment exists where such a feature is included or implemented, while all example embodiments are not limited thereto.

These embodiments are example embodiments, and thus, the disclosure is not limited thereto and may be realized in various other forms. As is traditional in the field, embodiments may be described and illustrated in terms of blocks, as shown in the drawings, which carry out a described function or functions. These blocks, which may be referred to herein as units or modules or the like, or by names such as device, logic, circuit, counter, comparator, generator, converter, or the like, may be physically implemented by analog and/or digital circuits including one or more of a logic gate, an integrated circuit, a microprocessor, a microcontroller, a memory circuit, a passive electronic component, an active electronic component, an optical component, and the like, and may also be implemented by or driven by software and/or firmware (configured to perform the functions or operations described herein).

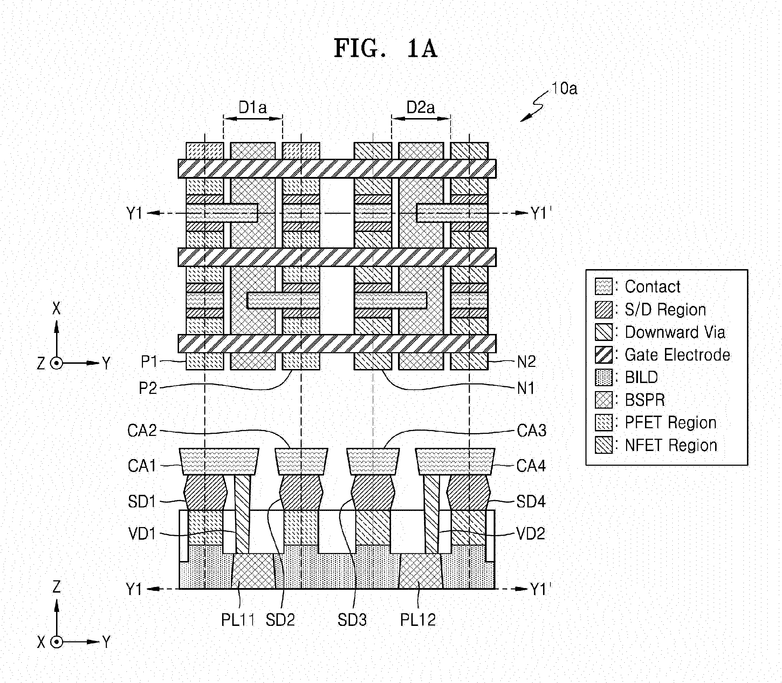

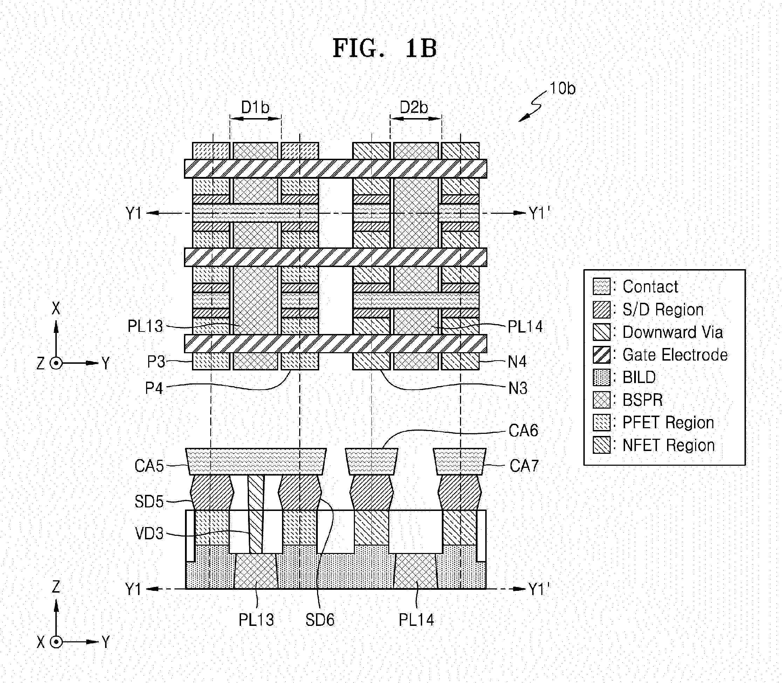

FIGS. 1A and 1B are diagrams illustrating layouts of an integrated circuit according to example embodiments. FIGS. 1A and 1B each show a plan view of the integrated circuit and a cross-sectional view of the integrated circuit taken along line Y1-Y1'. In the following descriptions of FIGS. 1A and 1B, repeated descriptions are omitted.

Herein, the X-axis direction may be referred to as a first direction (or first horizontal direction), the Y-axis direction may be referred to as a second direction (or second horizontal direction), and the Z-axis direction may be referred to as a vertical third direction. The first direction intersects/crosses the second direction. A plane consisting of the X and Y axes may be referred to as a horizontal plane, and a component provided in the +Z direction relative to other components may be referred to as being above the other components, and a component provided in the -Z direction relative to other components may be referred to as being under the other component. In addition, the area of the component may refer to the size occupied by the component in a plane parallel to the horizontal plane, and the width of the component may refer to a length in a direction orthogonal to a direction in which the component extends. A surface exposed in the +Z direction may be referred to as a top surface, a surface exposed in the -Z direction may be referred to as a bottom surface, and a surface exposed in the ±X direction or ±Y direction may be referred to as a side surface. A pattern made of a conductive material, such as a pattern of a wiring layer, may be referred to as a conductive pattern or may simply be referred to as a pattern. Also, a pattern extending in one direction may be referred to as a line.

In the drawings herein, only some layers may be shown for convenience of illustration, and vias connecting an upper pattern and a lower pattern may be displayed for understanding despite being located under the upper pattern. Also, for convenience of illustration, the gate electrodes are illustrated as continuously extending in the Y-axis direction, but it is noted that each of the gate electrodes may be divided into two or more gate electrodes by, for example, a gate cut.

According to an embodiment, an integrated circuit may include a power line that provides a power supply to a device or an electrical component. The power supply may be a positive supply voltage or negative supply voltage. The device may be a transistor, but the disclosure is not limited thereto. For example, as shown in FIG. 1A, an integrated circuit 10a may include a first power line PL11 that provides a positive supply voltage to a p-channel field effect transistor (PFET) formed in a first PFET region P1 and a second PFET region P2. The first power line PL11 may extend in the X-axis direction. In addition, the integrated circuit 10a may include a second power line PL12, which provides a negative supply voltage to a n-channel field effect transistor (NFET) formed in a first NFET region N1 and a second NFET region N2. The second power line PL12 may extend in the X-axis direction. Herein, a layer in which power lines are formed may be referred to as a power line layer. The power line may be made of any conductive material, as described below with reference to the drawings, and a power line may be referred to as a backside power rail (BSPR) when used to power standard cells. As shown in FIG. 1A, a backside interlayer dielectric (BILD) may be provided between the first power line PL1 and the second power line PL2.

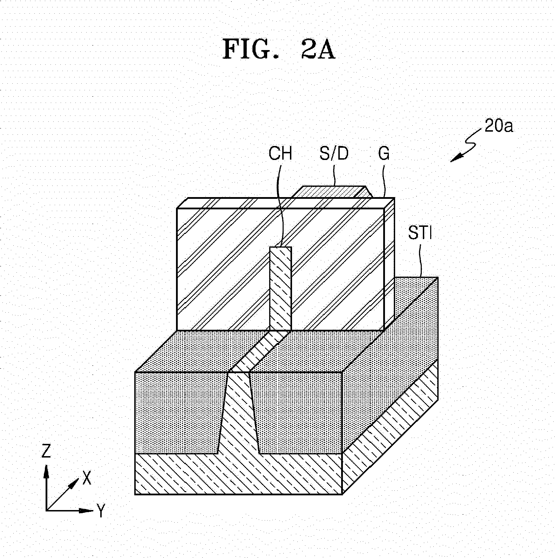

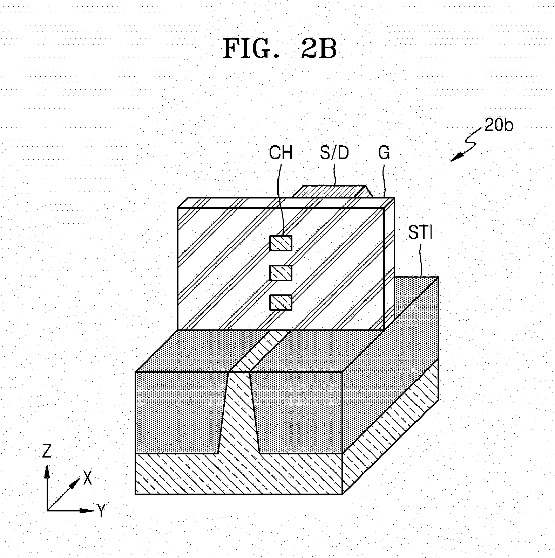

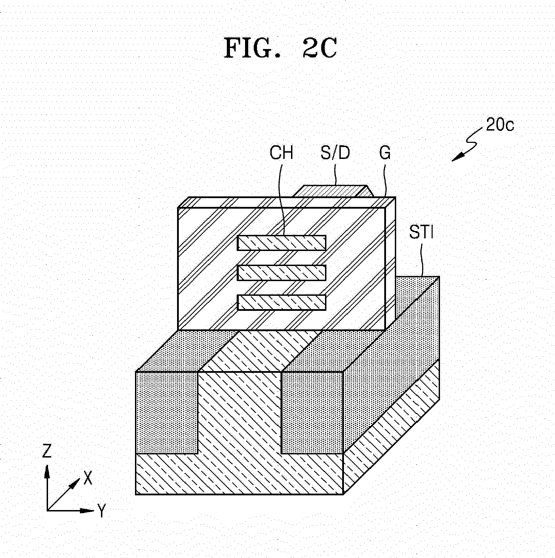

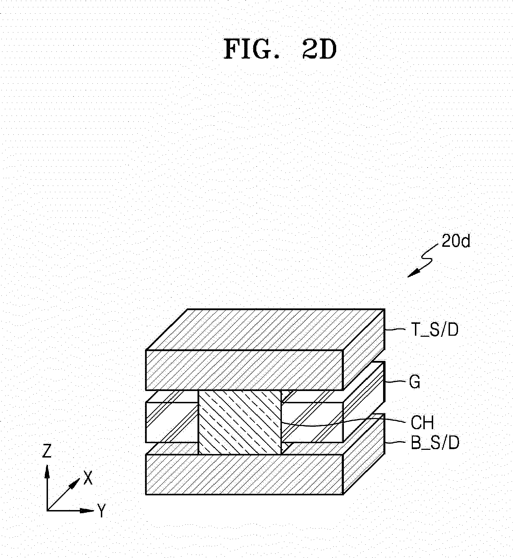

Referring to FIG. 1A, the integrated circuit 10a may include a first PFET region P1, a second PFET region P2, a first NFET region N1, and a second NFET region N2 extending in the X-axis direction. The integrated circuit 10a may include gate electrodes extending in the Y-axis direction. A source region or a drain region may be formed on the sides of the gate electrode, and contacts may be formed on the source region or the drain region. For example, a source region may be formed on first side of the gate electrode and a drain region may be formed on a second side of the gate electrode opposite to the first side. In some instances, the source region or the drain region may be referred to as source/drain S/D region or SD area for the sake of convenience. A channel may be formed between the source/drains under the gate electrode, and examples of the channel are described below with reference to FIGS. 2A, 2B, 2C and 2D.

According to an embodiment, an integrated circuit may include a power line extending below a transistor, and the transistor may be formed above a power line layer. For example, an integrated circuit may include a BSPR, as shown in FIGS. 1A and 1B. The first power line PL11 may extend in the X-axis direction under the first PFET region P1 and the second PFET region P2, and the second power line PL12 may extend in the X-axis direction under the first NFET region N1 and the second NFET region N2. According to an embodiment, a positive supply voltage may be applied to the first power line PL11 and a negative supply voltage may be applied to the second power line PL12.

The integrated circuit 10a may include vias coupled to power lines and contacts. For example, as shown in FIG. 1A, the first via VD1 may extend from the bottom surface of the first contact CA1 to the top surface of the first power line PL11 and the first via VD1 may be closer to the first source/drain area SD1 than the second source/drain area SD2. Accordingly, a positive supply voltage may be provided from the first power line PL11 to the first source/drain region SD1 through the first via VD1 and the first contact CA1. The first source/drain region SD1 may be a source of a PFET formed in the first PFET region P1, and the second source/drain region SD2 may be a drain of a PFET formed in the second PFET region P2. The second via VD2 may extend from the bottom surface of the fourth contact CA4 to the top surface of the second power line PL12 and may be closer to the fourth source/drain area SD4 than the third source/drain area SD3. Accordingly, a negative supply voltage may be provided from the second power line PL12 to the fourth source/drain region SD4 through the second via VD2 and the fourth contact CA4. The third source/drain region SD3 may be a drain of an NFET formed in the first NFET region N1, and the fourth source/drain region SD4 may be a source of an NFET formed in the second NFET region N2. Herein, like the first via VD 1 and the second via VD2, a via that extends downward from a contact to connect to a power line may be referred to as a downward via. On the other hand, a via that extends upward from the contact to connect to the pattern of the wiring layer may be referred to as an upward via.

Transistor regions (or source/drain regions) may be spaced apart from each other by a reference distance or more to connect downward vias to contacts. The reference distance may be a predefined or predetermined distance. For example, as shown in FIG. 1A, the first PFET region P1 and the second PFET region P2 may be spaced apart from each other in the Y-axis direction by a first distance D1a, and the first NFET region N1 and the second NFET region N2 may be spaced apart from each other in the Y-axis direction by a second distance D2a. According to an embodiment, the first distance D1a and the second distance D2a may be same. However, the disclosure is not limited thereto, and as such, according to another embodiment, the first distance D1a may be different from the second distance D2a. The first contact CA1 may extend in the Y-axis direction to connect to the first via VD1, and the first distance D1a may correspond to a length required for insulation between the first contact CA1 and the second contact CA2. In addition, the fourth contact CA4 may extend in the Y-axis direction for connection with the second via VD2, and the second distance D2a may correspond to a length required for insulation between the third contact CA3 and the fourth contact CA4. According to an embodiment, the first distance D1a may be the same as the second distance D2a.

Referring to FIG. 1B, an integrated circuit 10b may include a third PFET region P3, a fourth PFET region P4, a third NFET region N3, and a fourth NFET region N4 extending in the X-axis direction and may include gate electrodes extending in the Y-axis direction. The third power line PL13 may extend in the X-axis direction under the third PFET region P3 and the fourth PFET region P4, and the fourth power line PL14 may extend in the X-axis direction under the third NFET region N3 and the fourth NFET region N4. According to an embodiment, a positive supply voltage may be applied to the third power line PL 13 and a negative supply voltage may be applied to the fourth power line PL14.

According to an embodiment, transistors may be provided such that source regions are adjacent to each other in the Y-axis direction and a contact connecting the source regions to each other may extend in the Y-axis direction. For example, the fifth source/drain region SD5 may be a source of a PFET formed in the third PFET region P3, and the sixth source/drain region SD6 may be a source of a PFET formed in the fourth PFET region P4. The fifth contact CA5 may extend in the Y-axis direction and may be connected to the fifth source/drain area SD5 and the sixth source/drain area SD6. The third via VD3 may extend from the bottom surface of the fifth contact CA5 to the top surface of the third power line PL13. Accordingly, a positive supply voltage may be provided to the fifth source/drain region SD5 and the sixth source/drain region SD6 from the third power line PL13 through the third via VD3 and the fifth contact CA5.

In the integrated circuit 10a of FIG. 1A, the first source/drain region SD1 and the second source/drain region SD2 may be relatively far apart from each other for insulation between the first contact CA1 and the second contact CA2 connected to the first via VD1, and in the integrated circuit 10b of FIG. 1B, the fifth source/drain area SD5 and the sixth source/drain area SD6 may be relatively closely spaced apart from each other. Accordingly, the first distance D1b of FIG. 1B may be less than the first distance D1a of FIG. 1A (D1b < D1a), and the second distance D2b of FIG. 1B may also be less than the second distance D2a of FIG. 1A (D2b < D2a). As a result, the integrated circuit 10b of FIG. 1B may have a smaller area than the integrated circuit 10a of FIG. 1A. According to an embodiment, the third via VD3 may be provided in the center between the fifth source/drain region SD5 (or the third PFET region P3) and the sixth source/drain region SD6 (or the fourth PFET region P4). For example, the distance between the third via VD3 and the fifth source/drain region SD5 may be the same as the distance between the third via VD3 and the sixth source/drain region SD6.

FIGS. 2A, 2B, 2C and 2D are diagrams illustrating examples of devices according to example embodiments. For example, FIG. 2A shows a fin-field effect transistor (FinFET) 20a, FIG. 2B shows a gate-all-around field effect transistor (GAAFET) 20b, FIG. 2C shows a multi-bridge channel field effect transistor (MBCFET) 20c, and FIG. 2D shows a vertical field effect transistor (VFET) 20d. For convenience of illustration, FIGS. 2A to 2C show a state in which one of the two source/drain regions is removed, and FIG. 2D shows a cross-section of the VFET 20d with a plane parallel to the plane formed by the Y- and Z-axes and passing through the channel CH of VFET 20d.

Referring to FIG. 2A, the FinFET 20a may be formed by a fin-shaped active pattern extending in the X-axis direction between shallow trench isolations (STIs) and a gate electrode G extending in the Y-axis direction. Source/drain regions S/D may be formed on both sides of the gate electrode G, and thus, the source and drain may be spaced apart from each other in the X-axis direction. An insulating film may be formed between the channel CH and the gate electrode G. According to an embodiment, the FinFET 20a may be formed by a plurality of active patterns spaced apart from each other in the Y-axis direction and the gate electrode G.

Referring to FIG. 2B, the GAAFET 20b may be formed by active patterns (for example nanowires), spaced apart from each other in the Z-axis direction and extending in the X-axis direction, and the gate electrode G extending in the Y-axis direction. Source/drain regions S/D may be formed on both sides of the gate electrode G, and thus, the source and drain may be spaced apart from each other in the X-axis direction. An insulating film may be formed between the channel CH and the gate electrode G. The number of nanowires included in GAAFET 20b is not limited to that as shown in FIG. 2B.

Referring to FIG. 2C, the MBCFET 20c may be formed by active patterns (for example nanosheets), spaced apart from each other in the Z-axis direction and extending in the X-axis direction, and the gate electrode G extending in the Y-axis direction. Source/drain regions S/D may be formed on both sides of the gate electrode G, and thus, the source and drain may be spaced apart from each other in the X-axis direction. An insulating film may be formed between the channel CH and the gate electrode G. The number of nanosheets included in the MBCFET 20c is not limited to that as shown in FIG. 2C.

Referring to FIG. 2D, the VFET 20d has a top source/drain T_S/D and a bottom source/drain B_S/D spaced apart from each other in the Z-axis direction with the channel CH therebetween. The VFET 20d may include a gate electrode G surrounding the circumference of the channel CH between the top source/drain T_S/D and the bottom source/drain B_S/D. An insulating film may be formed between the channel CH and the gate electrode G.

In the following, an integrated circuit including the FinFET 20a or the MBCFET 20c is mainly described, but the devices included in the integrated circuit are not limited to the examples of FIGS. 2A, 2B, 2C and 2D. For example, an integrated circuit may include a ForkFET having a structure in which an N-type transistor and a P-type transistor are more closely related as the nanosheets for the P-type transistor and the nanosheets for the N-type transistor are separated by a dielectric wall. Also, the integrated circuit may include bipolar junction transistors as well as FETs, such as complementary FETs (CFETs), negative CFETs (NCFETs), carbon nanotube (CNT) FETs, and the like.

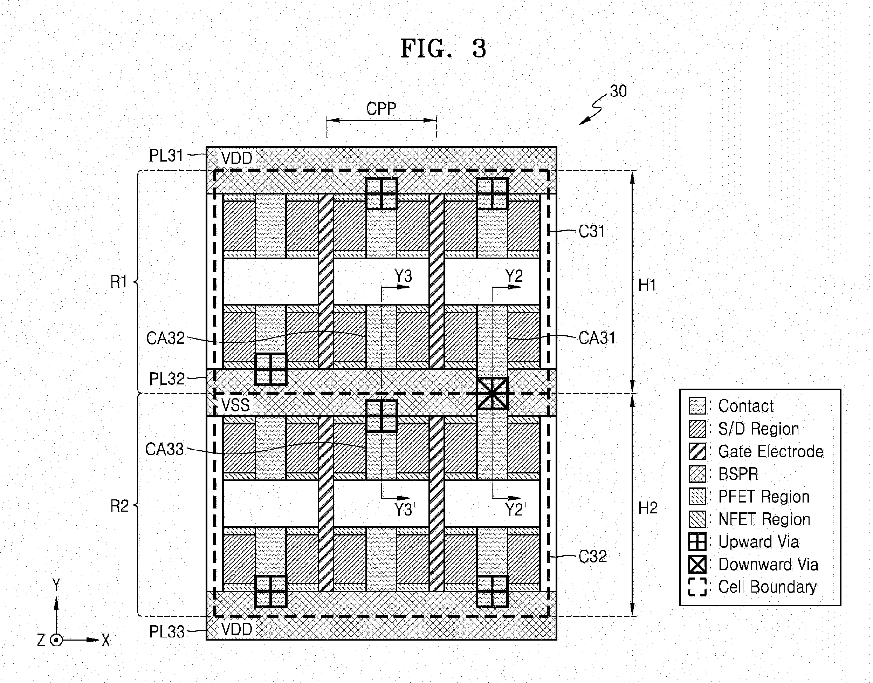

FIG. 3 is a plan view illustrating a layout of an integrated circuit according to an example embodiment. As shown in FIG. 3, an integrated circuit 30 may include a first cell C31, a second cell C32, a first power line PL31, a second power line PL32, and a third power line PL33.

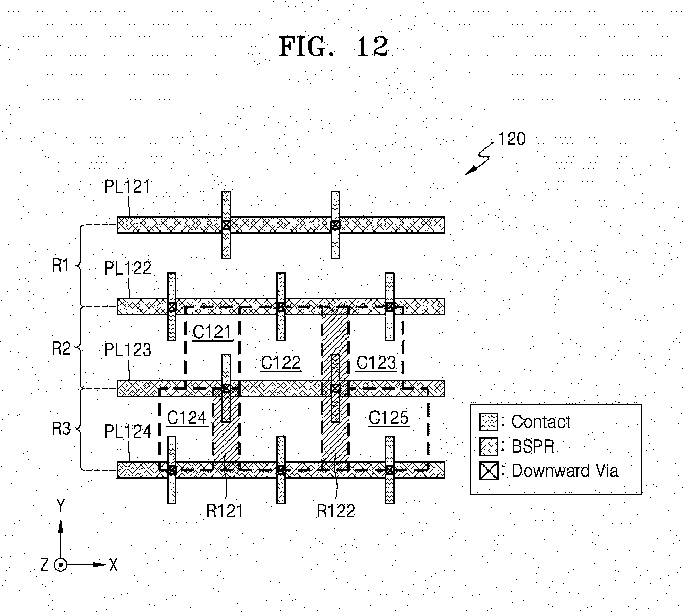

An integrated circuit may include a plurality of standard cells. A standard cell is a layout unit included in an integrated circuit, and may simply be referred to as a cell. Cells may include transistors and may be designed to perform predefined functions. For example, as shown in FIG. 3, the first cell C31 may be provided in a first row R1 extending in the X-axis direction, and the second cell C32 may be provided in a second row R2 adjacent to the first row R1, and extends in the X-axis direction. The height (i.e., the length in the Y-axis direction) of the first cell C31 may be the same as the first height H1 of the first row R1, and the height of the second cell C32 may be the same as the second height H2 of the second row R2. The first height H1 and the second height H2 may be the same or different. Like the first cell C31 and the second cell C32, a standard cell placed in one row may be referred to as a single height cell, and like the second cell C122 of FIG. 12 described below, a cell arranged consecutively in two or more rows may be referred to as a multi-height cell.

The gate electrodes may extend parallel to each other in the Y-axis direction. According to an embodiment, the gate electrodes may be parallel to each other at a constant pitch. For example, as shown in FIG. 3, the pitch of the gate electrodes may be referred to as contacted poly pitch (CPP). Accordingly, the contacts provided between the gate electrodes may also extend in the Y-axis direction in the CPP.

The power lines may extend along (or overlap with) the boundaries of rows in the X-axis direction in the power line layer. For example, as shown in FIG. 3, a positive supply voltage VDD may be applied to the first power line PL31, and the first power line PL31 may extend in the X-axis direction along the boundary of the first row R1. A negative supply voltage VSS may be applied to the second power line PL32, and the second power line PL32 may extend in the X-axis direction along the boundary between the first row R1 and the second row R2. A positive supply voltage VDD may be applied to the third power line PL33, and the third power line PL33 may extend in the X-axis direction along the boundary of the second row R2.

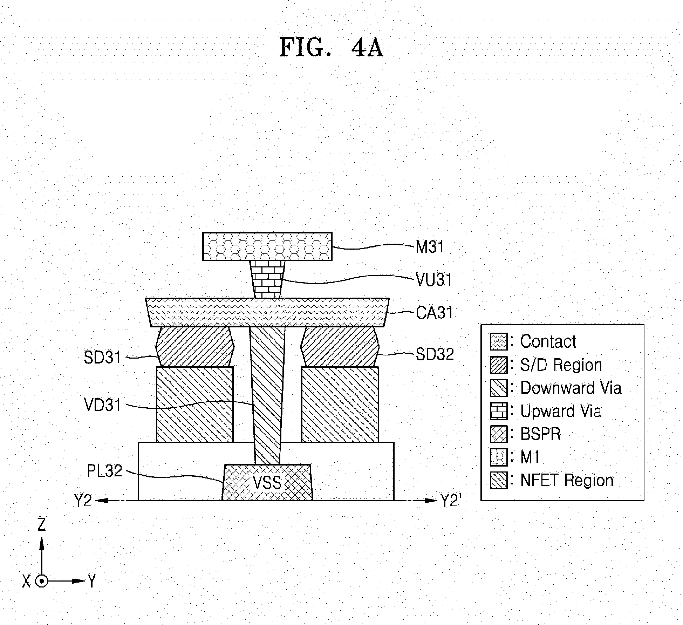

As described above with reference to FIG. 1B, the sources of the transistors may be adjacent to each other in the Y-axis direction, and the sources may be commonly connected to a contact extending in the Y-axis direction. For example, as shown in FIG. 3, the first contact CA31 may extend from the first cell C31 to the second cell C32 in the Y-axis direction and may be connected to a source of an NFET included in the first cell C31 (e.g., SD31 of FIG. 4A) and a source of an NFET included in the second cell C32 (e.g., SD32 of FIG. 4A). A downward via (e.g., VD31 of FIG. 4A) may be provided under the first contact CA31 and may be connected to the second power line PL32. According to an embodiment, the downward via may be aligned with the boundary between the first row R1 and the second row R2. For example, the center of the downward via may overlap the boundary between the first row R1 and the second row R2 in the Z-axis direction. According to an embodiment, an upward via may be provided on the first contact CA31 and may be connected to a pattern (e.g., M31 of FIG. 4A) extending in the X-axis direction in the wiring layer. An example of a cross-section of the integrated circuit 30 cut along the line Y2-Y2' is described below with reference to FIG. 4A.

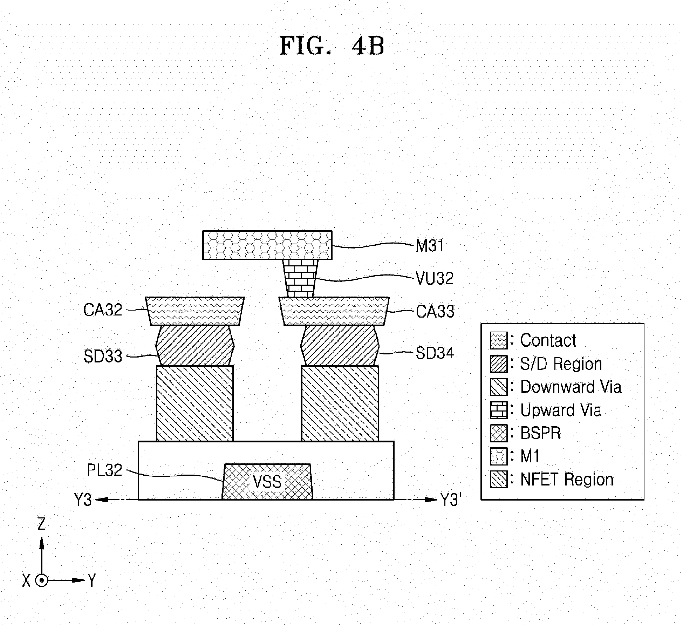

According to an embodiment, contacts respectively connected to source/drain regions corresponding to different nodes may be spaced apart from each other in the Y-axis direction. For example, the second contact CA32 may be connected to the drain (e.g., SD33 of FIG. 4B) of the NFET included in the first cell C31, and the third contact CA33 may be connected to a source (e.g., SD34 of FIG. 4B) of the NFET included in the second cell C32. As shown in FIG. 3, the second contact CA32 and the third contact CA33 may be spaced apart from each other in the Y-axis direction. An upward via may be provided on the third contact CA33, and the upward via may be connected to a pattern (e.g., M31 of FIG. 4B) extending in the X-axis direction in the wiring layer. A cross-section of the integrated circuit 30 cut along the line Y3-Y3' is described below with reference to FIG. 4B.

As shown in FIG. 3, when the first cell C31 and the second cell C32 are arranged so that the sources are adjacent to each other in the Y-axis direction, the first height H1 of the first cell C31 and the second height H2 of the second cell C2 may decrease, and the integrated circuit 30 may have a reduced area and/or a high degree of integration.

FIGS. 4A and 4B are cross-sectional views illustrating examples of a cross-section of an integrated circuit according to example embodiments. For example, the cross-sectional view of FIG. 4A shows an example of a cross-section through the integrated circuit 30 along line Y2-Y2' in FIG. 3, and the cross-sectional view of FIG. 4B shows an example of a cross-section of the integrated circuit 30 cut along the line Y3-Y3' in FIG. 3. In the following, FIGS. 4A and 4B will be described with reference to FIG. 3.

Referring to FIG. 4A, a negative supply voltage VSS may be applied to the second power line PL32, and the second power line PL32 may extend in the X-axis direction from the power line layer. The first contact CA31 may extend in the Y-axis direction and may be connected to the first source/drain region SD31 of the first cell C31 and the second source/drain region SD32 of the second cell C32. As described above with reference to FIG. 3, the first source/drain region SD31 may correspond to the source of the NFET included in the first cell C31, and the second source/drain region SD32 may correspond to the source of the NFET included in the second cell C32. The first downward via VD31 may extend in a vertical direction from the bottom surface of the first contact CA31 to the top surface of the second power line PL32. Accordingly, the negative supply voltage VSS may be provided from the second power line PL32 to the first source/drain region SD31 and the second source/drain region SD32 through the first downward via VD31 and the first contact CA31. According to an embodiment, the first downward via VD31 may be provided in the center between the first source/drain region SD31 and the second source/drain region SD32. For example, the distance between the first downward via VD31 and the first source/drain region SD31 may be the same as the distance between the first downward via VD31 and the second source/drain region SD32.

In the first wiring layer M1, the pattern M31 may extend in the X-axis direction. According to an embodiment, the first wiring layer M1 may refer to a wiring layer (e.g., a metal layer) closest to the device in the +Z-axis direction. The first upward via VU31 may extend from the top surface of the first contact CA31 to the bottom surface of the pattern M31 of the first wiring layer M1. Accordingly, the negative supply voltage VSS may be applied to the pattern M31 of the first wiring layer M1. According to an embodiment, the first upward via VU31 may be aligned with the first downward via VD31 in the Z-axis direction.

Referring to FIG. 4B, a negative supply voltage VSS may be applied to the second power line PL32, and the second power line PL32 may extend in the X-axis direction from the power line layer. The second contact CA32 may be connected to the third source/drain region SD33 in the first cell C31, and the third contact CA33 may be connected to the fourth source/drain region SD34 in the second cell C32. As described above with reference to FIG. 3, the third source/drain region SD33 may correspond to the drain of the NFET included in the first cell C31, and the fourth source/drain region SD34 may correspond to the source of the NFET included in the second cell C32. To supply a negative supply voltage to the fourth source/drain region SD34, the second upward via VU32 may extend from the top surface of the third contact CA33 to the bottom surface of the pattern M31 of the first wiring layer M1. As described above with reference to FIG. 4A, a negative supply voltage VSS may be applied to the pattern M31 of the first wiring layer M1, and accordingly, the negative supply voltage VSS may be provided from the pattern M31 of the first wiring layer M1 to the fourth source/drain region SD34 through the second upward via VU32 and the third contact CA33. According to an embodiment, the third contact CA33 may extend in the Y-axis direction to be connected to the second upward via VU32 and may have a longer length in the Y-axis direction than the second contact CA32.

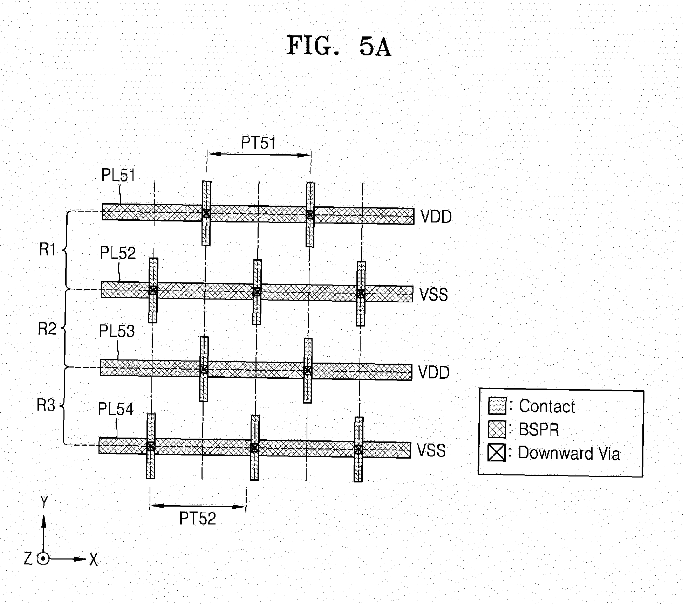

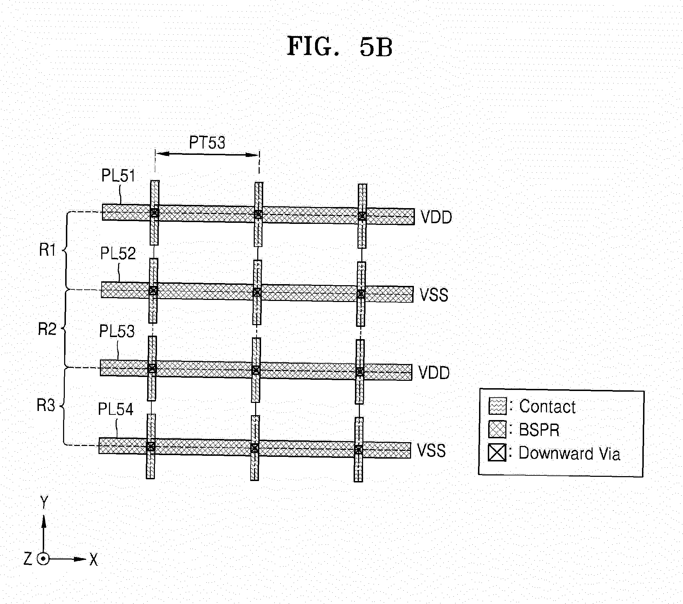

FIGS. 5A and 5B are diagrams illustrating layouts of an integrated circuit according to example embodiments. For example, FIGS. 5A and 5B show a first power line PL51, a second power line PL52, a third power line PL53, and a fourth power line PL54 extending in the X-axis direction. The first power line PL51 may be provided along the boundary of the first row R1, the second power line PL52 may be provided along a boundary between the first row R1 and the second row R2, the third power line PL53 may be provided along a boundary between the second row R2 and the third row R3, and the fourth power line PL54 may be provided along the boundary of the third row R3. Also, FIGS. 5A and 5B shows contacts connected to the first to fourth power lines PL51 to PL54 through downward vias. According to an embodiment, downward vias connected to power lines may be regularly arranged, and contacts connected to downward vias may also be regularly arranged. Due to the regularly placed downward vias and contacts, a low IR-drop, that is, an improved power delivery network, may be achieved, and accordingly, a supply voltage may be stably provided to devices included in standard cells.

Referring to FIG. 5A, downward vias connected to the first power line PL51 and the third power line PL53 to which the positive supply voltage VDD is applied may be arranged to have a first pitch PT51 in the X-axis direction. Accordingly, the contacts may also extend in the Y-axis direction with the first pitch PT51. In addition, downward vias connected to the second power line PL52 and the fourth power line PL54 to which the negative supply voltage VSS is applied may be arranged to have a second pitch PT52. Accordingly, the contacts may also extend in the Y-axis direction with the second pitch PT52. According to an embodiment, the first pitch PT51 may be the same as the second pitch PT52. However, the disclosure is not limited thereto, and as such, the first pitch PT51 may be different from the second pitch PT52.

As shown in FIG. 5A, contacts connected to the first power line PL51 to which the positive supply voltage VDD is applied through downward vias and contacts connected to the third power line PL53 to which the positive supply voltage VDD is applied through downward vias may be aligned along the Y-axis direction. Meanwhile, contacts connected to the second power line PL52 or the fourth power line PL54 to which the negative supply voltage VSS is applied through downward vias may not be aligned in the Y-axis direction with contacts connected to the first power line PL51 or with contacts connected to the third power line PL53. Also, contacts connected to the second power line PL52 through downward vias may be aligned with contacts connected to the fourth power line PL54 through downward vias in the Y-axis direction.

Referring to FIG. 5B, downward vias connected to the first to fourth power lines PL51 to PL54 may be arranged to have a third pitch PT53 in the X-axis direction. Accordingly, the contacts may also be extended in the Y-axis direction at the third pitch PT53. Downward vias and contacts connected to the first to fourth power lines PL51 to PL54 may be aligned in the Y-axis direction. In the following description, a structure as illustrated in FIG. 5A, in which contacts to which a positive supply voltage VDD is applied and contacts to which a negative supply voltage VSS is applied are not aligned in the Y-axis direction will be mainly referred to, but the disclosure is not limited to the example embodiments.

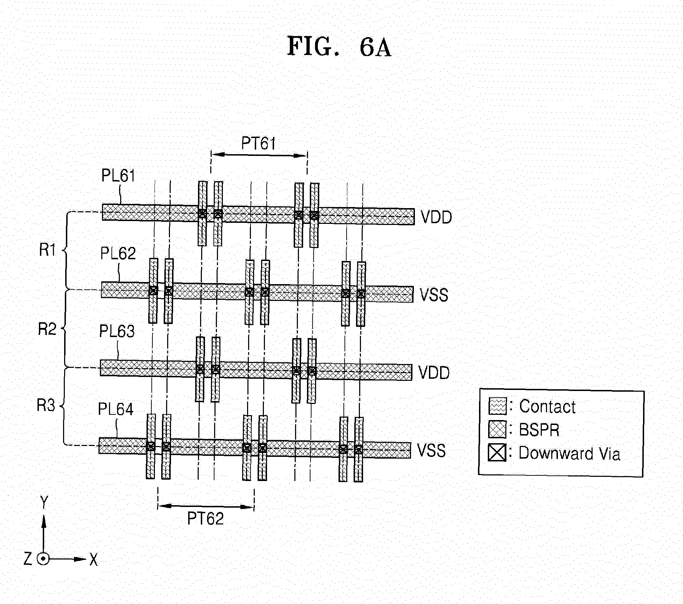

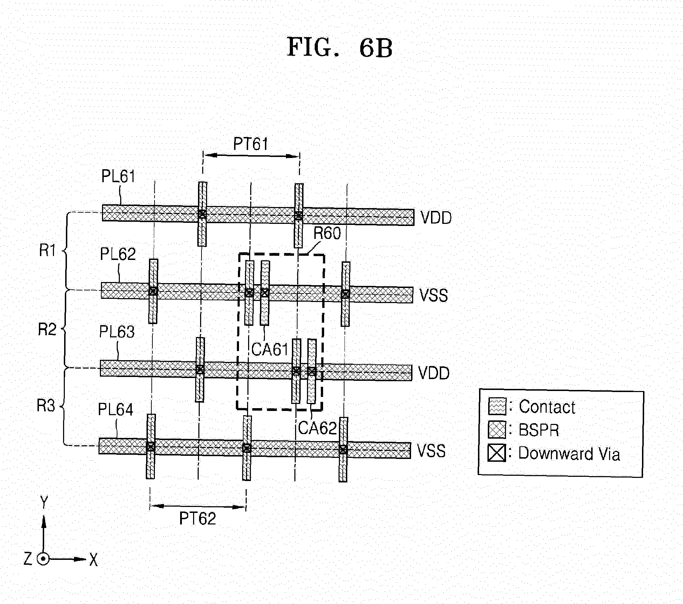

FIGS. 6A and 6B are diagrams illustrating layouts of an integrated circuit according to example embodiments. For example, FIGS. 6A and 6B show a first power line PL61, a second power line PL62, a third power line PL63, and a fourth power line PL64 extending in the X-axis direction. The first power line PL61 may be provided along the boundary of the first row R1, the second power line PL62 may be provided along a boundary between the first row R1 and the second row R2, the third power line PL63 may be provided along a boundary between the second row R2 and the third row R3, and the fourth power line PL64 may be provided along the boundary of the third row R3. Also, FIGS. 6A and 6B shows contacts connected to the first to fourth power lines PL61 to PL64 through downward vias. As described above with reference to FIGS. 5A and 5B, downward vias connected to power lines may be regularly arranged, and contacts connected to downward vias may also be regularly arranged. In the following descriptions of FIGS. 6A and 6B, repeated descriptions are omitted.

Referring to FIG. 6A, similar to the example of FIG. 5A, contacts connected to the first power line PL61 to which the positive supply voltage VDD is applied through downward vias and contacts connected to the third power line PL63 to which the positive supply voltage VDD is applied through downward vias may be aligned in the Y-axis direction, and contacts connected to the second power line PL62 or the fourth power line PL64 to which the negative supply voltage VSS is applied through downward vias may not be aligned in the Y-axis direction with contacts connected to the first power line PL61 or with contacts connected to the third power line PL63. Also, contacts connected to the second power line PL62 through downward vias may be aligned with contacts connected to the fourth power line PL64 through downward vias in the Y-axis direction.

As shown in FIG. 6A, contacts connected to the first power line PL61 or the third power line PL63 through downward vias may include contact pairs each composed of two mutually adjacent contacts, and the contact pairs may be spaced apart from each other at a first pitch PT61 in the X-axis direction. In addition, contacts connected to the second power line PL62 or the fourth power line PL64 through downward vias may include contact pairs each composed of two mutually adjacent contacts, and the contact pairs may be spaced apart from each other at a second pitch PT62 in the X-axis direction. However, the disclosure is not limited to contact pairs composed of two mutually adjacent contacts, and as such, according to another embodiment, contacts connected to the first to fourth power lines PL61 to PL64 may be include a contact group including two or more contacts. For example, instead of contact pairs including two mutually adjacent contacts, a contact group may be provided including three or more mutually adjacent contacts. According to an embodiment, the first pitch PT61 may be the same as the second pitch PT62. The integrated circuit of FIG. 6A may provide a reduced IR-drop than the integrated circuit of FIG. 5A.

Referring to FIG. 6B, contacts may be locally added among regularly placed contacts. For example, in the same layout as that of FIG. 5A, a region R60 consuming a large amount of current may be identified, and a first contact CA61 and a second contact CA62 may be added to the region R60. Accordingly, contact pairs (or contact groups) in FIG. 6A may be globally provided, while contact pairs (or contact groups) in FIG. 6B may be locally provided.

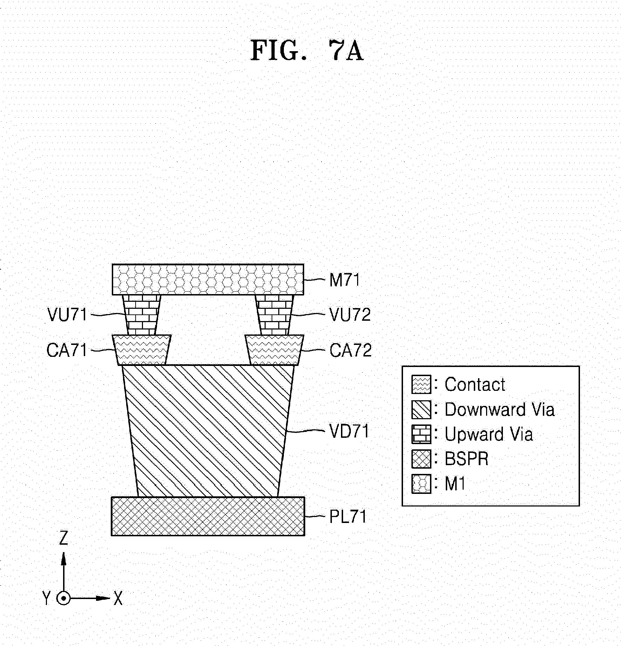

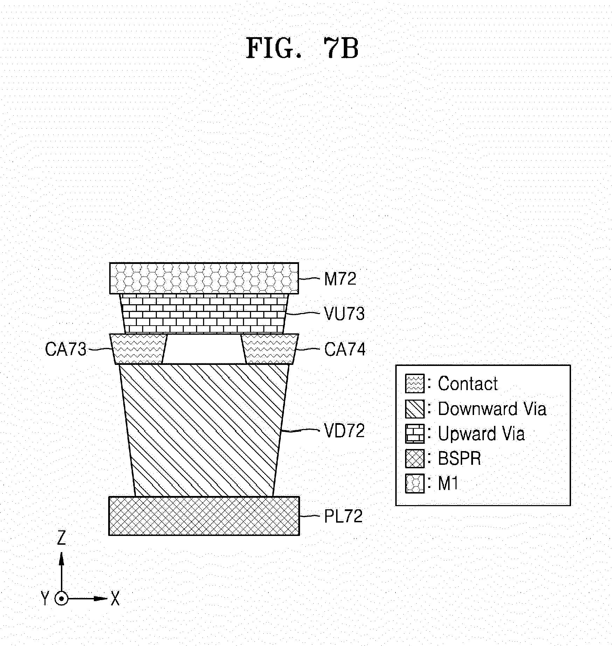

FIGS. 7A and 7B are cross-sectional views illustrating examples of a cross-section of an integrated circuit according to example embodiments. For example, the cross-sectional views of FIGS. 7A and 7B represent examples of cross-sections of a structure including a contact pair composed of mutually adjacent contacts, as described above with reference to FIGS. 6A and 6B. As discussed above with reference to FIGS. 6A and 6B, a lower IR-drop may be provided by the contact pair.

Referring to FIG. 7A, the first contact CA71 and the second contact CA72 may be adjacent to each other in the X-axis direction and constitute one contact pair. The first downward via VD71 may have a top surface connected to the first contact CA71 and the second contact CA72 and may have a bottom surface connected to the first power line PL71. A via having a shape extending in a horizontal direction (e.g., an X-axis direction), like the first downward via VD71, may be referred to as a bar-type via. As a bar-type via, the first downward via VD71 may provide a lower IR-drop as compared to a via that does not extend in the horizontal direction. The first pattern M71 of the first wiring layer M1 may extend in the X-axis direction on the first contact CA71 and the second contact CA72. The first upward via VU71 may be connected to the first contact CA71 and the first pattern M71, and the second upward via VU72 may be connected to the second contact CA72 and the first pattern M71.

Referring to FIG. 7B, the third contact CA73 and the fourth contact CA74 may be adjacent to each other in the X-axis direction and constitute one contact pair. The second downward via VD72 may have a top surface connected to the fourth contact CA74 and the third contact CA73 and may have a bottom surface connected to the second power line PL72. As a bar-type via, the second downward via VD72 may provide a lower IR-drop. The second pattern M72 of the first wiring layer M1 may extend in the X-axis direction on the third contact CA73 and the fourth contact CA74. The third upward via VU73 may have a bottom surface connected to the third contact CA73 and the fourth contact CA74 and may have a top surface connected to the second pattern M72. As a bar-type via, the third upward via VU73 may provide a lower IR-drop.

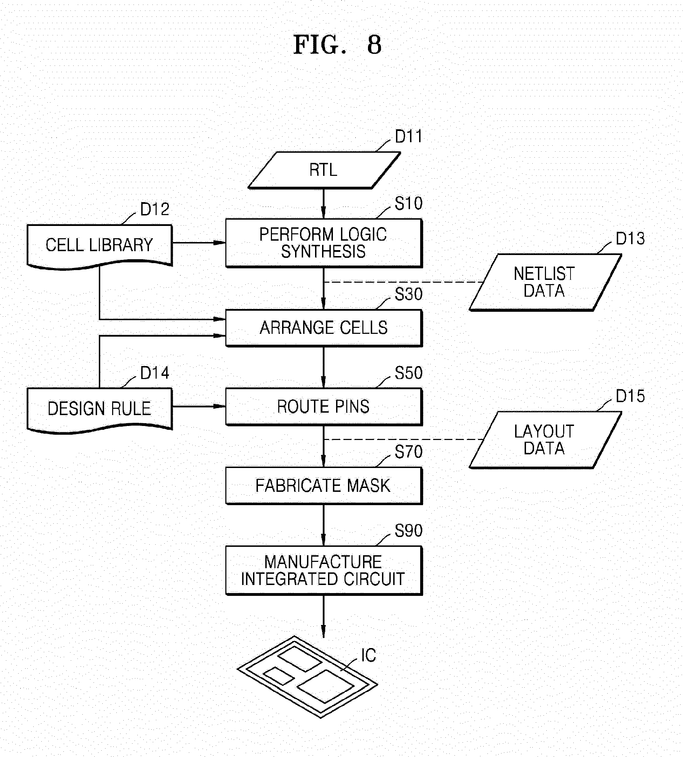

FIG. 8 is a flowchart illustrating a method of fabricating an integrated circuit IC, according to an example embodiment. For example, the flowchart of FIG. 8 shows an example of a method of fabricating an integrated circuit IC that includes standard cells. As shown in FIG. 8, a method of manufacturing an integrated circuit IC may include operations S10, S30, S50, S70, and S90. However, the disclosure is not limited to the operations illustrated in FIG. 8, and as such, according to another embodiment, one or more operations may be added or omitted. Also, the order of the operations is not limited to the illustration in FIG. 8, and as such, according to another embodiment, an order of the operations may be different.

In operation S10, a logic synthesis operation for generating netlist data D13 from RTL data D11 may be performed. For example, a semiconductor design tool (e.g., a logic synthesis tool) may perform logic synthesis with reference to a cell library D12, from the RTL data D11 generated using VHSIC Hardware Description Language (VHDL) or Hardware Description Language (HDL) such as Verilog, and generate netlist data D13 including a bitstream or a netlist. The netlist data D13 may correspond to an input of place and routing to be described below.

According to an embodiment, the cell library (or standard cell library) D12 may include information about standard cells, such as information about functions, characteristics, layouts, and the like. According to an embodiment, the cell library D12 may define a plurality of standard cells each corresponding to different layouts and corresponding to the same function. According to an embodiment, the cell library D12 may define standard cells of various heights.

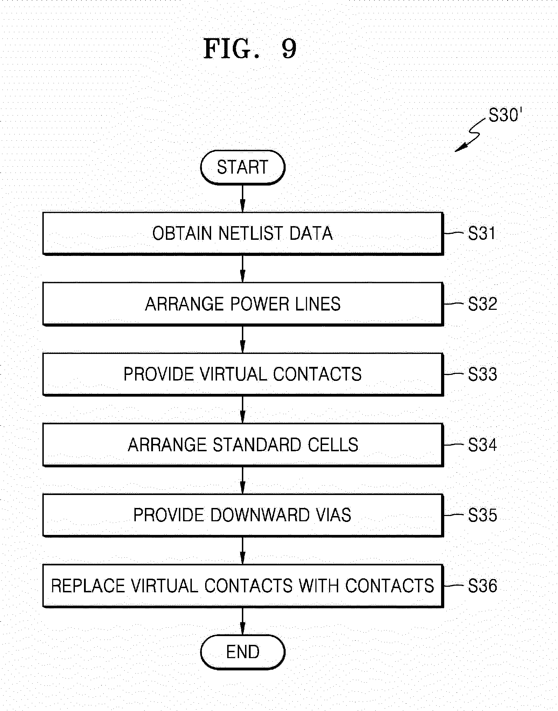

In operation S30, cells may be placed or arranged. For example, a semiconductor design tool (e.g., a Placement & Routing (P&R) tool) may arrange standard cells used in the netlist data D13 by referring to the cell library D12. According to an embodiment, the semiconductor design tool may place standard cells in a row extending in the X-axis direction. That is, the semiconductor design tool may arrange the standard cells in a manner, such that, the standard cells extend in the X-axis direction, and the arranged standard cells may be electrically connected to a power line extending in the X-axis direction under a transistor. An example of operation S30 is described with reference to FIG. 9. According to an embodiment, the semiconductor design tool may refer to the design rules D14 to arrange the standard cells.

Design rules D14 may include requirements that the layout of an integrated circuit IC must comply with. For example, the design rule D14 may include requirements for a space between patterns in the same layer, the minimum width of a pattern, a routing direction of a wiring layer, and the like. According to an embodiment, the design rule D14 may define a minimum intra-track spacing of wiring layers.

In operation S50, pins of the cells may be routed. For example, the semiconductor design tool may generate interconnections that electrically connect the output pins and input pins of the deployed standard cells, and generate layout data D15 defining standard cells deployed and interconnections generated. The interconnection may include vias in a via layer and/or a pattern of a wiring layer. The layout data D15 may have a format such as, for example, GDSII, and may include geometric information of cells and interconnections. The semiconductor design tool may refer to the design rule D14 while routing the pins of the cells. Layout data D15 may correspond to the output of arrangement and routing. Operation S50 alone, or operation S30 and operation S50 collectively, may be referred to as a method of designing an integrated circuit. Herein, the layout data D15 may be referred to as output data.

In operation S70, an operation of fabricating a mask may be performed. For example, optical proximity correction (OPC) for correcting a distortion phenomenon such as refraction caused by characteristics of light in photolithography may be applied to the layout data D15. Patterns on the mask may be defined to form patterns provided on a plurality of layers based on OPC-applied data, and at least one mask (or photomask) for forming patterns of each of a plurality of layers may be manufactured. According to an embodiment, the layout of an IC may be limitedly modified in operation S70, and the limited modification of the IC in operation S70 is post-processing for optimizing the structure of the IC, and may be referred to as design polishing.

In operation S90, an operation of manufacturing an integrated circuit IC may be performed. For example, an IC may be fabricated by patterning a plurality of layers using at least one mask fabricated in operation S70. For example, the front-end-of-line (FEOL) process may include planarizing and cleaning a wafer, forming a trench, forming a well, forming a gate electrode, and forming sources and drains. With the FEOL, individual devices such as transistors, capacitors, resistors, and the like may be formed on a substrate. For example, the back-end-of-line (BEOL) process may include performing silicidation on a gate, a source and a drain, adding a dielectric, performing planarization, forming a hole, adding a metal layer, forming a via, and forming a passivation layer. With the BEOL, individual devices such as transistors, capacitors, and resistors may be interconnected. According to an embodiment, the middle-of-line (MOL) may be performed between the FEOL and the BEOL, and contacts may be formed on separate devices. Then, the integrated circuit IC may be packaged in a semiconductor package and used as a component in various applications.

FIG. 9 is a flowchart showing a method of manufacturing an integrated circuit, according to an example embodiment. For example, the flowchart of FIG. 9 shows an example of operation S30 of FIG. 8. As described above with reference to FIG. 8, cells may be arranged in operation S30' of FIG. 9. As shown in FIG. 9, operation S30' may include operations S31 to S36. However, the disclosure is not limited to the operations illustrated in FIG. 9, and as such, according to another embodiment, one or more operations may be added or omitted. Also, the order of the operations is not limited to the illustration in FIG. 9, and as such, according to another embodiment, an order of the operations may be different.

Referring to FIG. 9, netlist data may be obtained in operation S31. For example, as described above with reference to FIG. 8, netlist data may be generated as a result of logical synthesis. The netlist data may define standard cells included in an integrated circuit and may define a connection relationship between standard cells. Herein, netlist data may be referred to as input data.

In operation S32, power lines may be arranged. As described above with reference to the drawings, power lines may extend in the X-axis direction in the power line layer below the devices, that is, the transistors, and each of the power lines may be configured so that a positive or negative supply voltage is applied. According to an embodiment, the power lines may extend along the borders of the rows along which the standard cells are aligned.

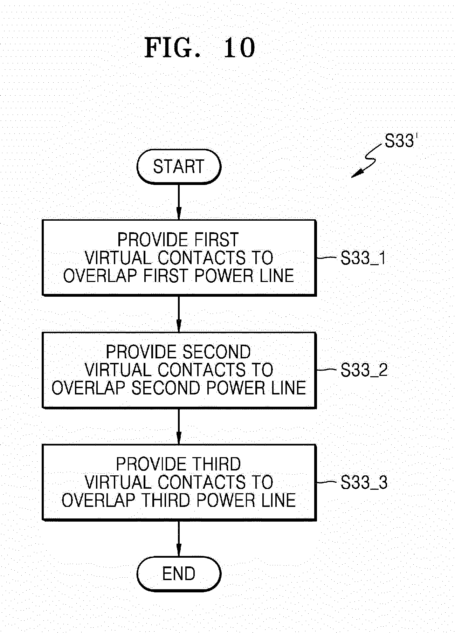

In operation S33, virtual contacts may be provided. For example, the virtual contacts may be provided or arranged to overlap the power lines. Each of the virtual contacts may extend in the Y-axis direction and overlap one of the power lines arranged in operation S32 in the Z-axis direction. For example, virtual contacts may be pre-arranged in the same manner as the contacts of FIG. 5A. Virtual contacts may indicate points at which downward vias are to be placed and, as described below, may be used to place standard cells. An example of operation S33 is described below with reference to FIG. 10.

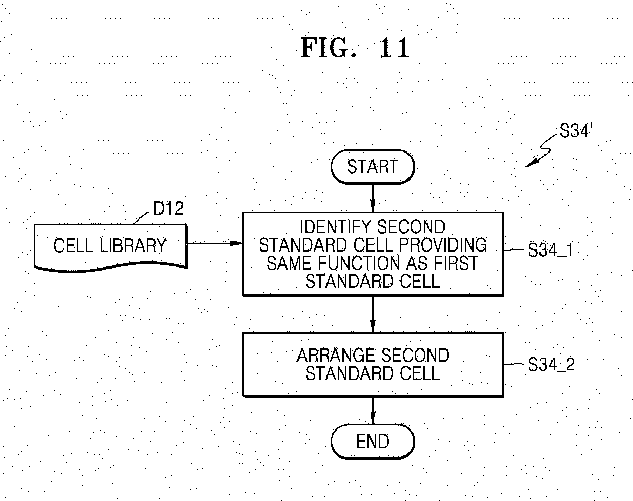

In operation S34, standard cells may be arranged. For example, standard cells may be arranged based on the virtual contacts arranged in operation S33. Standard cells may be placed such that the source of the transistor overlaps the virtual contact. Accordingly, standard cells of a reduced area (or height) may be provided, and the integrated circuit may have a reduced area and/or high degree of integration. An example of operation S34 is described below with reference to FIG. 11.

In operation S35, downward vias may be provided. For example, downward vias may be provided to overlap the virtual contacts provided in operation S33, and each of the downward vias may be connected to one of the power lines provided in operation S32. According to an embodiment, downward vias may be arranged to align with the boundaries of the rows.

In operation S36, virtual contacts may be replaced with contacts. By the replaced contacts, the sources of different standard cells may be electrically connected. For example, the contact may extend from the first standard cell to the second standard cell and may be connected to a source of a transistor included in the first standard cell and a source of a transistor included in the second standard cell. Also, the replaced contact may be connected to the downward via provided in operation S35, and accordingly, the sources may be electrically connected to the power line.

FIG. 10 is a flowchart showing a method of manufacturing an integrated circuit, according to an example embodiment. For example, the flowchart of FIG. 10 shows an example of operation S33 of FIG. 9. As described above with reference to FIG. 9, virtual contacts may be arranged in operation S33' of FIG. 10. Virtual contacts may be replaced with contacts after standard cells are deployed. As shown in FIG. 10, operation S33' may include operations S33_1 to S33_3. Hereinafter, FIG. 10 will be described with reference to FIGS. 5A and 5B, and the contacts in FIGS. 5A and 5B are considered to be virtual contacts.

Referring to FIG. 10, first virtual contacts may be arranged to overlap the first power line PL51 in operation S33_1. For example, the first virtual contacts may be arranged at regular intervals to overlap the first power line PL51 configured to apply the positive supply voltage VDD to a component. The spacing (or pitch) of the first virtual contacts may be predefined, may be defined by the design rule D14 of FIG. 8, or may be defined by additional input data defining the integrated circuit.

In operation S33_2, second virtual contacts may be arranged to overlap the second power line PL52. For example, the second virtual contacts may be arranged at regular intervals to overlap the second power line PL52 configured to apply the negative supply voltage VSS. According to an embodiment, as described above with reference to FIG. 5A, the second virtual contacts may not be aligned with the first virtual contacts provided in operation S33_1 in the Y-axis direction. According to an embodiment, as described above with reference to FIG. 5B, the second virtual contacts may be aligned with the first virtual contacts provided in operation S33_1 in the Y-axis direction.

In operation S33_3, third virtual contacts may be arranged to overlap the third power line. For example, the third virtual contacts may be arranged at regular intervals to overlap the third power line PL53 configured to apply the positive supply voltage VDD to a component. According to an embodiment, as described above with reference to FIGS. 5A and 5B, the third virtual contacts may be aligned with the first virtual contacts provided in operation S33_1 in the Y-axis direction. While Figure 10 illustrates the operations for providing virtual contacts to the first, second and third power lines, this is by way of example only. Additional virtual contacts may also be provided to additional power lines in the same manner as described above in connection with operations S33_1 to S33_3 (e.g. fourth virtual contacts arranged to overlap the fourth power line).

FIG. 11 is a flowchart showing a method of manufacturing an integrated circuit, according to an example embodiment. For example, the flowchart of FIG. 11 shows an example of operation S34 of FIG. 9. As described above with reference to FIG. 9, standard cells may be arranged in operation S34' of FIG. 11. As shown in FIG. 11, operation S34' may include operation S34_1 and operation S34_2.

Referring to FIG. 11, a second standard cell providing the same function as the first standard cell may be identified in operation S34_1. In the process of sequentially arranging the standard cells defined in the netlist data, when arranging the next first standard cell adjacent to the already arranged standard cell, a source of a transistor included in the first standard cell may not overlap the virtual contact. According to an embodiment, the cell library D12 may define a plurality of standard cells that each provide the same functionality but with different layouts. For example, the cell library D12 may define a plurality of standard cells that provide the same function but have different locations of the sources of transistors. Accordingly, when the second standard cell may provide the same function as the first standard cell and is placed adjacent to the already placed standard cell, the second standard cell, including a source of a transistor overlapping the virtual contact, may be identified.

In operation S34_2, a second standard cell may be arranged. For example, a second standard cell may be provided adjacent to an already provided standard cell, and a source of a transistor included in the second standard cell may overlap the virtual contact.

FIG. 12 is a diagram illustrating a layout of an integrated circuit 120 according to an example embodiment. For example, FIG. 12 shows a first power line PL121, a second power line PL 122, a third power line PL123, and a fourth power line PL124 extending in the X-axis direction. The first power line PL121 may be provided along the boundary of the first row R1, the second power line PL122 may be provided along a boundary between the first row R1 and the second row R2, the third power line PL123 may be provided along a boundary between the second row R2 and the third row R3, and the fourth power line PL124 may be provided along the boundary of the third row R3. Also, FIG. 12 shows contacts connected to the first to fourth power lines PL 121 to PL124 through downward vias. As shown in FIG. 12, the integrated circuit 120 may include a first cell C121 and a third cell C123 provided in the second row R2, may include the fourth cell C124 and the fifth cell C125 provided in the third row R3, and may include the second cell C122 continuously provided in the second row R2 and the third row R3.

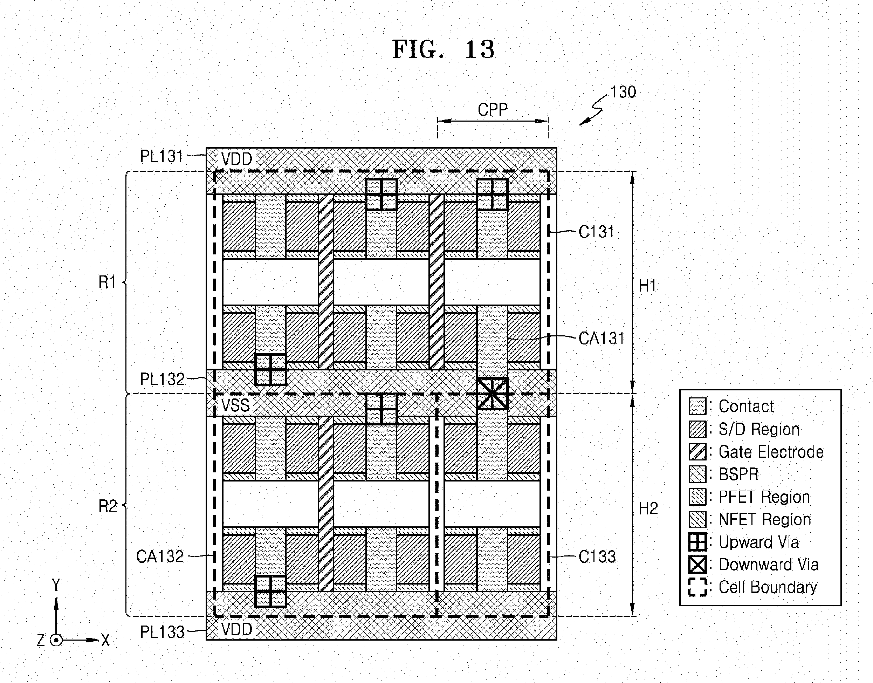

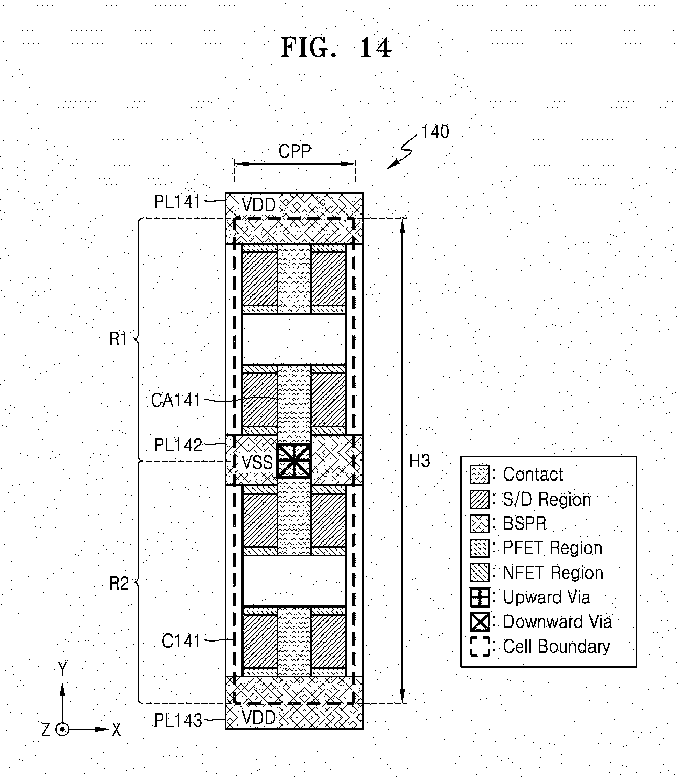

As described above with reference to FIG. 9, when standard cells are arranged such that a source overlaps a virtual contact, a space may occur between the standard cells. For example, a first region R121 in which no standard cells are provided may occur in the third row R3 between the fourth cell C124 and the second cell C122. In addition, the second region R122 in which no standard cells are provided is formed between the second cell C122, the third cell C123, and the fifth cell C125, and may occur continuously in the second row R2 and the third row R3. As is described below with reference to FIGS. 13 and 14, filler cells may be provided to reinforce the power delivery network, and operation S34 of FIG. 8 may include arranging filler cells between the arranged standard cells such that the source/drain regions overlap the virtual contacts. Accordingly, filler cells may be provided in the first region R121 and the second region R122.

FIG. 13 is a diagram illustrating a layout of an integrated circuit 130 according to an example embodiment. As shown in FIG. 13, the integrated circuit 130 may include a first cell C131, a second cell C132, a third cell C133, a first power line PL131, a second power line PL132 and a third power line PL133. The first cell C131 may be provided in the first row R1 at the first height H1, and the second cell C132 and the third cell C133 may be provided in the second row R2 at the second height H2. The first to third power lines PL131 to PL133 may extend in the X-axis direction and may be configured to receive a positive supply voltage VDD, a negative supply voltage VSS, and a positive supply voltage VDD, respectively.

The first cell C131 and the second cell C132 are functional cells and may be defined by netlist data. The third cell C133 may be defined by a cell library as a filler cell and provided adjacent to the first cell C131 and the second cell C132. The third cell C133 is a single-height cell, may have the second height H2, and may overlap the virtual contact. For example, as shown in FIG. 13, the first contact CA131 corresponding to the virtual contact may extend from the first cell C131 to the third cell C133. A downward via connected to the bottom surface of the first contact CA131 and the top surface of the second power line PL132 may be provided. In addition, an upward via connected to the top surface of the first contact CA131 and connected to the bottom surface of the pattern of the first wiring layer may be provided. Accordingly, an IR-drop may be reduced in a path through which the transistor (i.e., the NFET) included in the first cell C131 receives the negative supply voltage VSS.

FIG. 14 is a diagram illustrating a layout of an integrated circuit 140 according to an example embodiment. As shown in FIG. 14, the integrated circuit 140 may include a first cell C141, a first power line PL141, a second power line PL142, and a third power line PL143. The first cell C141 is a multi-height cell and may be continuously provided in the first row R1 and the second row R2, and may have a third height H3 that is the sum of the heights of the first row R1 and the heights of the second row R2. The first to third power lines PL141 to PL143 may extend in the X-axis direction and are configured to receive a positive supply voltage VDD, a negative supply voltage VSS, and a positive supply voltage VDD, respectively.

The first cell C141 may be a filler cell and may be provided between standard cells defined by a netlist. The first cell C141 may overlap the virtual contact. For example, as shown in FIG. 14, the first contact CA141 corresponding to the virtual contact may extend from the first cell C141. A downward via connected to the bottom surface of the first contact CA141 and the top surface of the second power line PL142 may be provided. In addition, an upward via connected to the top surface of the first contact CA141 and connected to the bottom surface of the pattern of the first wiring layer may be provided. Accordingly, a connection between the second power line PL142 and the pattern of the first wiring layer may be further strengthened.

According to an embodiment, a multi-height cell filler cell may be composed of two single height cells filler cells. For example, the first cell C141 of FIG. 14 may include a cell composed of the third cell C133 of FIG. 13 and the third cell C133 that is flipped around the X axis. Accordingly, only single-height filler cells may be provided, and multi-height cells such as the first cell C141 of FIG. 14 may be provided by combining two or more filler cells.

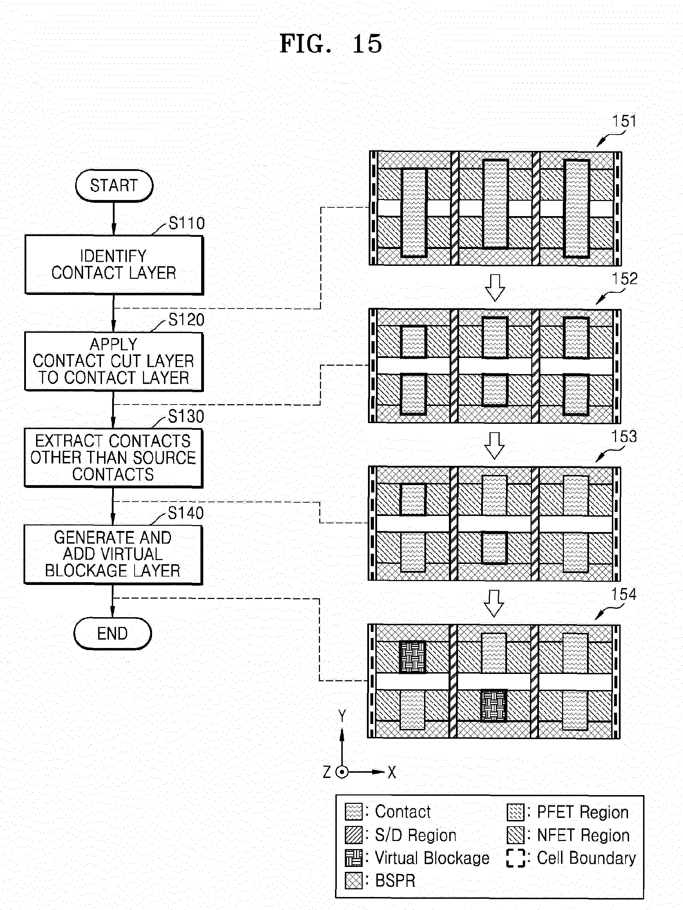

FIG. 15 is a flowchart illustrating a method of fabricating an integrated circuit, according to an example embodiment, and a diagram illustrating examples of a layout. For example, the flowchart of FIG. 15 shows a method of adding a virtual blockage layer to the layout of standard cells to place standard cells based on virtual contacts, and the first to fourth layouts 151 to 154 of FIG. 15 show examples of layouts corresponding to data generated in the process of performing a method of adding a virtual blockage layer. As shown in FIG. 15, the method of adding a virtual blockage layer may include operations S110 to S140.

Referring to FIG. 15, a contact layer may be identified in operation S110. For example, as indicated by a thick line in the first layout 151, a contact layer in which contacts are formed may be identified. In operation S120, a contact cut layer may be applied to the contact layer. In a semiconductor process, a contact may be formed parallel to the Y-axis and then divided by a contact cut. The contact cut layer may include contact cuts, and the contact cut layer may be applied to the contact layer identified in operation S110. For example, as indicated by a thick line in the second layout 152, each of the contacts of the first layout 151 may be divided into two contacts by contact cut.

In operation S130, contacts other than source contacts may be extracted. For example, the contact may be connected to the via to provide a supply voltage to the source of the transistor and may have an extended length for connection with the via. Accordingly, as indicated by a thick line in the third layout 153, a contact connected to the source of the transistor, that is, a source contact may be extracted.

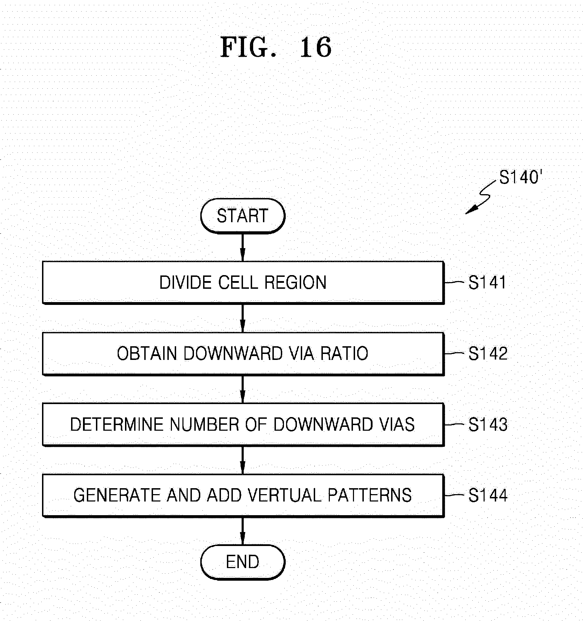

In operation S140, a virtual blockage layer may be generated and added. For example, prevention patterns corresponding to the contacts extracted in operation S130 may be generated, and a virtual blockage layer including the prevention patterns may be generated. Accordingly, as indicated by a thick line in the fourth layout 154, a virtual blockage layer including prevention patterns may be generated. The standard cell may be arranged so that the prevention pattern does not overlap with the virtual contact, and accordingly, the source of the transistor may overlap with the virtual contact. An example of operation S140 is described below with reference to FIG. 16.

According to an embodiment, unlike the example of FIG. 15, a virtual layer including virtual patterns corresponding to source contacts may be generated and added. In this case, the standard cell may be arranged so that the virtual pattern overlaps with the virtual contact. According to an embodiment, the method of FIG. 15 may be performed between the operation S10 and the operation S30 of FIG. 8. For example, the standard cell in FIG. 15 is a standard cell defined in the netlist data D13 in FIG. 8. According to an embodiment, the method of FIG. 15 may be performed before performing the method of FIG. 8. For example, the standard cell in FIG. 15 is a standard cell included (or defined) in the cell library D12 of FIG. 8.

FIG. 16 is a flowchart illustrating a method of fabricating an integrated circuit, according to an example embodiment. For example, the flowchart of FIG. 16 shows an example of operation S140 of FIG. 15. In operation S140' of FIG. 16, a virtual pattern of virtual layer may be generated and added. As shown in FIG. 16, operation S140' may include operations S141 to S144.

Referring to FIG. 16, a cell region may be divided in operation S141. When a contact connected to a source of transistor is connected to a power line through a downward via, the transistor may stably receive a supply voltage. As described above with reference to the drawings, arranging a drain of transistor adjacent to a downward via may not easy. When downward vias are arranged at all contacts connected to the sources of transistors, the area of integrated circuit may increase. Accordingly, downward vias may be selectively arranged at sources of transistors according to predefined criteria. For example, for stable supply of supply voltage, the number of downward vias required for a given area (or ratio of downward vias per unit area) can be defined. To this end, the cell region of a standard cell may be divided into at least one region each having a given area.

In operation S142, a downward via ratio can be obtained (e.g. a number of downward vias per unit area). As described above, the number of downward vias required for a given area may be predefined. According to an embodiment, the design rule D14 of FIG. 8 may define the downward via ratio, and the downward via ratio may be obtained from the design rule D14.

In operation S143, the number of downward vias can be determined. For example, in the region divided in operation S141, the number of downward vias corresponding to the downward via ratio obtained in operation S142 may be determined. According to an embodiment, a power requirement may be added, and the number of downward vias may be determined to be greater than the number of downward vias corresponding to the downward via ratio according to the power requirement.

In operation S144, virtual patterns may be generated and added. For example, to meet the number of downward vias determined in operation S143, the virtual patterns may be generated and added at points corresponding to the downward vias in each of the divided regions in operation S141.

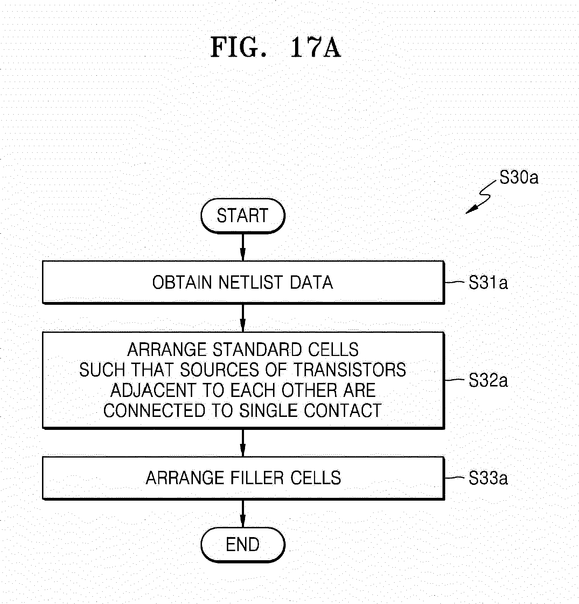

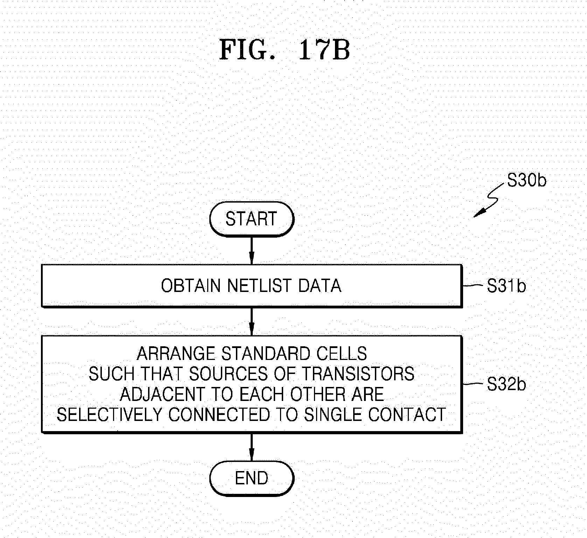

FIGS. 17A and 17B are flowcharts illustrating methods of fabricating an integrated circuit, according to an example embodiments. For example, the flow charts of FIGS. 17A and 17B show examples of operation S30 of FIG. 8. As described above with reference to FIG. 8, cells may be arranged in operation S30a of FIG. 17A and operation S30b of FIG. 17B. Unlike S30' in FIG. 9 in which standard cells are arranged based on virtual contacts, in operation S30a in FIG. 17A and operation S30b in FIG. 17B, standard cells are arranged based on relationships with adjacent standard cells, that is, context. In the following descriptions of FIGS. 17A and 17B, repeated descriptions are omitted.

Referring to FIG. 17A, operation S30a may include operation S31a, operation S32a, and operation S33a. In operation S31a, netlist data may be obtained. The netlist data may define standard cells included in an integrated circuit. In operation S32a, standard cells may be arranged such that the sources of adjacent transistors are connected to a single contact. For example, a standard cell may be arranged adjacent to a source of a transistor in another standard cell such that a source of a transistor included in the standard cell may be connected to a downward via through a contact. According to an embodiment, a layout of standard cell may be modified (e.g., mirror symmetric) and a standard cell having the modified layout may be arranged such that sources are adjacent.

In operation S33a, filler cells may be arranged. When standard cells are arranged such that sources of adjacent transistors are connected to a single contact in operation S32a, spaces may occur between the arranged standard cells. Accordingly, filler cells may be placed in the spaces.

Referring to FIG. 17B, operation S30b may include operation S31b and operation S32b. In operation S31b, netlist data may be obtained. The netlist data may define standard cells included in an integrated circuit. In operation S31b, standard cells may be arranged such that sources of adjacent transistors are selectively connected to a single contact. For example, when standard cells are arranged as in operation S32a of FIG. 17A, a supply voltage may be stably provided to the standard cells, while the area of the integrated circuit may be increased. Accordingly, in operation S30b, standard cells may be arranged such that sources are selectively connected to a single contact according to predefined criteria.

According to an embodiment, based on a ratio of sources and drains included in a standard cell, a width of standard cell (i.e., the length in the X-axis direction) may be determined. For example, if the ratio of sources and drains is low and/or the width of the standard cell is great, a greater number of sources may be connected to the downward via through contacts.

According to an embodiment, at least one source to be connected to a downward via through a contact among sources included in a standard cell may be determined depending on a type of the standard cell. For example, in a standard cell that require a stable supply of supply voltage, such as a flip-flop, a clock network, a driving cell, etc., a large number of sources, for example, all of the sources, may be determined to be connected to the downward via.

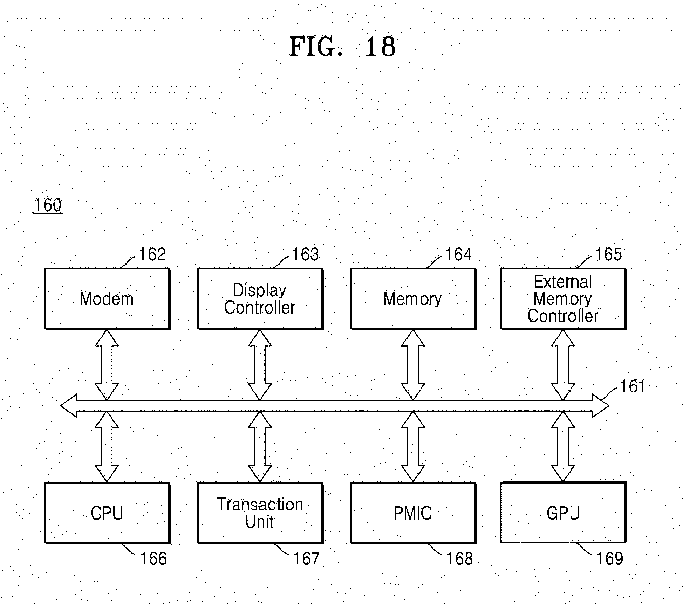

FIG. 18 is a block diagram illustrating a system on chip (SoC) 160 according to an example embodiment. The SoC 160 is a semiconductor device and may include an integrated circuit according to an example embodiment. The SoC 160 implements complex blocks such as intellectual property (IP) performing various functions on a single chip, and the SoC 160 may be designed by the method of designing an integrated circuit according to example embodiments, and accordingly, the SoC 160 may have a reduced area and/or a high degree of integration. Referring to FIG. 18, the SoC 160 may include a modem 162, a display controller 163, a memory 164, an external memory controller 165, a central processing unit (CPU) 166, a transaction unit 167, a power management integrated circuit (PMIC) 168, and a graphics processing unit (GPU) 169, and each functional block of the SoC 160 may communicate with each other through a system bus 161.

The CPU 166, which may control the operation of the SoC 160 at the highest level, may control the operation of the other components 162 to 169. The modem 162 may demodulate a signal received from the outside of the SoC 160, or may modulate a signal generated inside the SoC 160 and transmit the modulated signal to the outside. The external memory controller 165 may control an operation of transmitting and receiving data to and from an external memory device connected to the SoC 160. For example, programs and/or data stored in the external memory device may be provided to the CPU 166 or the GPU 169 under the control of the external memory controller 165. The GPU 169 may execute program instructions related to graphic processing. The GPU 169 may receive graphic data through the external memory controller 165, and may transmit graphic data processed by the GPU 169 to the outside of the SoC 160 through the external memory controller 165. The transaction unit 167 may monitor data transactions of each functional block, and the PMIC 168 may control power supplied to each functional block according to the control of the transaction unit 167. The display controller 163 may transmit data generated inside the SoC 160 to the display by controlling the display (or display device) outside the SoC 160. The memory 164 may include non-volatile memory, such as Electrically Erasable Programmable Read-Only Memory (EEPROM) and flash memory, and may also include volatile memory, such as Dynamic Random Access Memory (DRAM) and Static Random Access Memory (SRAM).

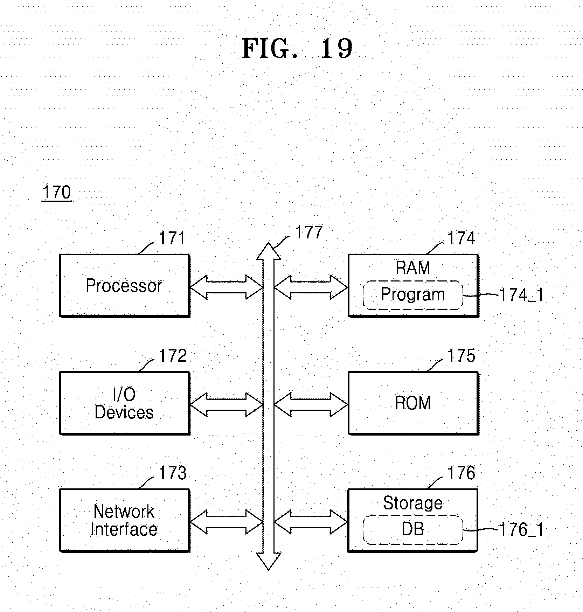

FIG. 19 is a block diagram illustrating a computing system 170 including a memory storing a program according to an example embodiment. A method of designing an integrated circuit, for example, at least some of the operations of the flowchart described above, according to example embodiments, may be performed on a computing system (or computer) 170.

The computing system 170 may be a fixed computing system, such as a desktop computer, a workstation, a server, and the like and may be a portable computing system, such as a laptop computer. As shown in FIG. 19, the computing system 170 may include a processor 171, input/output (I/O) devices 172, a network interface 173, a random access memory (RAM) 174, a read only memory (ROM) 175, and a storage device 176. The processor 171, the I/O devices 172, the network interface 173, the RAM 174, the ROM 175, and the storage device 176 may be connected to the bus 177, and may communicate with each other through the bus 177.

The processor 171 may be referred to as a processing unit, and for example, may include at least one core capable of executing an arbitrary instruction set (e.g., Intel Architecture-32 (IA-32), 64-bit extension IA-32, x86-64, PowerPC, Sparc, MIPS, ARM, IA-64, and the like), such as a micro-processor, an application processor (AP), a digital signal processor (DSP), and a GPU. For example, the processor 171 may access memory, that is, the RAM 174 or the ROM 175 through the bus 177, and may execute instructions stored in the RAM 174 or the ROM 175.

The RAM 174 may store a program 174_1 or at least a portion thereof for a method of designing an integrated circuit according to an example embodiment, and the program 174_1 may cause the processor 171 to perform at least some of the operations included in a method of designing an integrated circuit, for example, the methods of FIG. 8. That is, the program 174_1 may include a plurality of instructions executable by the processor 171, and a plurality of instructions included in the program 174_1 may allow the processor 171 to perform at least some of the operations included in the above-described flowchart, for example.

The storage device 176 may not lose stored data even when the power supplied to the computing system 170 is cut off. For example, the storage device 176 may include a nonvolatile memory device or a storage medium such as a magnetic tape, an optical disk, or a magnetic disk. Further, the storage device 176 may be detachable from the computing system 170. The storage device 176 may store the program 174_1 according to an example embodiment, and before the program 174_1 is executed by the processor 171, the program 174_1 or at least a portion thereof may be loaded from the storage device 176 into the RAM 174. Alternatively, the storage device 176 may store a file written in a program language, and the program 174_1 generated by a compiler or the like from a file or at least a part thereof may be loaded into the RAM 174. Also, as shown in FIG. 19, the storage device 176 may store the database 176_1, and the database 176_1 may include information necessary for designing an integrated circuit, for example, information on designed blocks, the cell library D12 of FIG. 8, and/or the design rules D14.

The storage device 176 may store data to be processed by the processor 171 or data processed by the processor 171. That is, the processor 171 may generate data by processing data stored in the storage device 176 according to the program 174_1 and may store the generated data in the storage device 176. For example, the storage device 176 may store the RTL data D11, netlist data D13, and/or layout data D15 of FIG. 8.

The input/output devices 172 may include an input device, such as a keyboard and a pointing device, and may include an output device, such as a display device and a printer. For example, through the I/O devices 172, a user may trigger the execution of the program 174_1 by the processor 171, input the RTL data D11 and/or the netlist data D13 of FIG. 8, and check the layout data D15 of FIG. 8.

The network interface 173 may provide access to a network external to the computing system 170. For example, a network may include multiple computing systems and communication links, and the communication links may include wired links, optical links, wireless links, or any other type of links.

While the inventive concept has been particularly shown and described with reference to embodiments thereof, it will be understood that various changes in form and details may be made therein without departing from the scope of the following claims.
Further Embodiments are set out in the following Numbered Paragraphs (NPs):
NP1. An integrated circuit comprising:
   a first cell provided in a first row extending in a first horizontal direction;
   a second cell provided in a second row extending in the first horizontal direction, the first row and the second row being adjacent to each other;
   a first power line extending in the first horizontal direction along a first boundary between the first row and the second row in a power line layer, the first power line configured to receive a first supply voltage;
   a first contact extending from the first cell to the second cell in a second horizontal direction intersecting the first horizontal direction; and
   a first via extending in a vertical direction from a bottom surface of the first contact to a top surface of the first power line.
NP2. The integrated circuit of NP1, wherein the first via is aligned with the first boundary.
NP3. The integrated circuit of NP1, wherein the first cell comprises a first source/drain region and the second cell comprises a second source/drain region,
   wherein the first contact contacts the first source/drain region and the second source/drain region, and
   wherein the first via extends in the vertical direction between the first source/drain region and the second source/drain region.
NP4. The integrated circuit of NP3, wherein a distance between the first via and the first source/drain region is equal to a distance between the first via and the second source/drain region.
NP5. The integrated circuit of NP1, further comprising:
   a first wiring pattern extending in the first horizontal direction along the first boundary in a first wiring layer; and
   a first upward via extending from a top surface of the first contact to a bottom surface of the first wiring pattern in the vertical direction.
NP6. The integrated circuit of NP5, further comprising:
   a second contact extending from the first cell in the second horizontal direction; and
   a second upward via extending from a top surface of the second contact to a bottom surface of the first wiring pattern in the vertical direction.
NP7. The integrated circuit of NP1, wherein the first cell comprises at least two gate electrodes extending in the second horizontal direction with a first pitch, and
   wherein the second cell has a length of the first pitch in the first horizontal direction.
NP8. The integrated circuit of NP1, further comprising a plurality of gate electrodes extending in the second horizontal direction with a first pitch,
   wherein the first cell and the second cell have a length of the first pitch in the first horizontal direction.
NP9. The integrated circuit of NP1, further comprising a third contact extending in the second horizontal direction parallel to the first contact,
   wherein the first via contacts the bottom surface of the third contact.
NP10. The integrated circuit of NP1, further comprising:
   a plurality of contacts extending in the second horizontal direction parallel to the first contact; and
   a plurality of vias extending in the vertical direction from bottom surfaces of the plurality of contacts to a top surface of the first power line, respectively,
   wherein the plurality of contacts are arranged at equal intervals in the first horizontal direction.
NP11. The integrated circuit of NP 1, further comprising:
   a third cell provided in the second row;
   a fourth cell extending in the first horizontal direction and provided in a third row adjacent to the second row;
   a second power line extending in the first horizontal direction along a second boundary between the second row and the third row in the power line layer, the second power line configured to receive a second supply voltage;
   a fourth contact extending from the third cell to the fourth cell in the second horizontal direction; and
   a second via extending from a bottom surface of the fourth contact to a top surface of the second power line in the vertical direction.
NP12. The integrated circuit of NP11, wherein the second via is aligned with the second boundary.
NP13. The integrated circuit of NP11, wherein the third cell comprises a third source/drain region and the fourth cell comprises a fourth source/drain region,
   wherein the fourth contact contacts the third source/drain region and the fourth source/drain region, and
   wherein the second via extends in the vertical direction between the third source/drain region and the fourth source/drain region.
NP14. The integrated circuit of NP13, wherein a distance between the second via and the third source/drain region is equal to a distance between the second via and the fourth source/drain region.
NP15. A method of manufacturing an integrated circuit, the method comprising:
   obtaining first input data including first information about the integrated circuit including a plurality of standard cells;
   arranging, in a power line layer, a plurality of power lines extending in a first horizontal direction;
   providing a plurality of virtual contacts, each extending in a second horizontal direction intersecting with the first horizontal direction and overlapping one of the plurality of power lines;
   arranging the plurality of standard cells based on the plurality of virtual contacts; and
   generating output data including second information of a layout including the plurality of standard cells,
   wherein the arranging of the plurality of standard cells comprises arranging a first source region of a first transistor of a first standard cell, among the plurality of standard cells, to overlap a first virtual contact, among the plurality of virtual contacts.

## Claims

1. An integrated circuit comprising:
a first cell provided in a first row extending in a first horizontal direction;
a second cell provided in a second row extending in the first horizontal direction, the first row and the second row being adjacent to each other;
a first power line extending in the first horizontal direction along a first boundary between the first row and the second row in a power line layer, the first power line configured to receive a first supply voltage;
a first contact extending from the first cell to the second cell in a second horizontal direction intersecting the first horizontal direction; and
a first via extending in a vertical direction from a bottom surface of the first contact to a top surface of the first power line.

2. The integrated circuit of claim 1, wherein the first via is aligned with the first boundary.

3. The integrated circuit of claim 1 or claim 2, wherein the first cell comprises a first source/drain region and the second cell comprises a second source/drain region,
wherein the first contact contacts the first source/drain region and the second source/drain region, and
wherein the first via is provided between the first source/drain region and the second source/drain region.

4. The integrated circuit of claim 3, wherein a distance between the first via and the first source/drain region is equal to a distance between the first via and the second source/drain region.

5. The integrated circuit of any preceding claim, further comprising:
a first wiring pattern extending in the first horizontal direction along the first boundary in a first wiring layer; and
a first upward via extending from a top surface of the first contact to a bottom surface of the first wiring pattern in the vertical direction.

6. The integrated circuit of claim 5, further comprising:
a second contact extending from the first cell in the second horizontal direction; and
a second upward via extending from a top surface of the second contact to a bottom surface of the first wiring pattern in the vertical direction.

7. The integrated circuit of any preceding claim, wherein the first cell comprises at least two gate electrodes extending in the second horizontal direction with a first pitch, and
wherein the second cell has a length of the first pitch in the first horizontal direction.

8. The integrated circuit of any one of claims 1 - 6, further comprising a plurality of gate electrodes extending in the second horizontal direction with a first pitch,
wherein the first cell and the second cell have a length of the first pitch in the first horizontal direction.

9. The integrated circuit of any preceding claim, further comprising a third contact extending in the second horizontal direction parallel to the first contact,
wherein the first via contacts the bottom surface of the third contact.

10. The integrated circuit of any one of claims 1 - 8, further comprising:
a plurality of contacts extending in the second horizontal direction parallel to the first contact; and
a plurality of vias extending in the vertical direction from bottom surfaces of the plurality of contacts to a top surface of the first power line, respectively,
wherein the plurality of contacts are arranged at equal intervals in the first horizontal direction.

11. The integrated circuit of any preceding claim 1, further comprising:
a third cell provided in the second row;
a fourth cell extending in the first horizontal direction and provided in a third row adjacent to the second row;
a second power line extending in the first horizontal direction along a second boundary between the second row and the third row in the power line layer, the second power line configured to receive a second supply voltage;
a fourth contact extending from the third cell to the fourth cell in the second horizontal direction; and
a second via extending from a bottom surface of the fourth contact to a top surface of the second power line in the vertical direction.

12. The integrated circuit of claim 11, wherein the second via is aligned with the second boundary.

13. The integrated circuit of claim 11 or claim 12, wherein the third cell comprises a third source/drain region and the fourth cell comprises a fourth source/drain region,
wherein the fourth contact contacts the third source/drain region and the fourth source/drain region, and
wherein the second via is provided between the third source/drain region and the fourth source/drain region.

14. The integrated circuit of claim 13, wherein a distance between the second via and the third source/drain region is equal to a distance between the second via and the fourth source/drain region.

15. A method of manufacturing an integrated circuit, the method comprising:
obtaining first input data including first information about the integrated circuit including a plurality of standard cells;
arranging, in a power line layer, a plurality of power lines extending in a first horizontal direction;
providing a plurality of virtual contacts, each extending in a second horizontal direction intersecting with the first horizontal direction and overlapping one of the plurality of power lines;
arranging the plurality of standard cells based on the plurality of virtual contacts; and
generating output data including second information of a layout including the plurality of standard cells,
wherein the arranging of the plurality of standard cells comprises arranging a first source region of a first transistor of a first standard cell, among the plurality of standard cells, to overlap a first virtual contact, among the plurality of virtual contacts.
